# EUROPEAN PATENT APPLICATION

(11) **EP 4 804 776 A1**
(43) Date of publication of application: **09.09.2026**
(21) Application number: 26161394.7
(22) Date of filing: 27.02.2026
(51) Int. Cl.: H10K 59/38, H10K 59/40, H10K 59/80

(54) **DISPLAY DEVICE AND ELECTRONIC DEVICE INCLUDING THE SAME**

(30) Priority: 06.03.2025 KR 20250028968; 12.05.2025 KR 20250061232
(71) Applicant: Samsung Display Co., Ltd., Yongin-si, Gyeonggi-do 17113 (KR)
(72) Inventor: KIM, Kyeong Jong, 17113 Yongin-si (KR); KIM, Su Jeong, 17113 Yongin-si (KR); KIM, Woo Young, 17113 Yongin-si (KR); LAZO MARTINEZ, Israel Esteban, 17113 Yongin-si (KR); LEE, Jung Woo, 17113 Yongin-si (KR); LEE, Jin Hyeong, 17113 Yongin-si (KR)
(74) Representative: Taor, Simon Edward William

(57) **Abstract**

A display device includes a substrate, first to third light emitting units on the substrate and configured to emit light of first to third wavelength bands, respectively, an encapsulation layer on the first to third light emitting units, first to third color filters on the encapsulation layer overlapping the first to third light emitting units, respectively, in a thickness direction of the substrate and configured to selectively transmit the light of the first to third wavelength bands, respectively a first reflection pattern on the encapsulation layer and overlapping the first light emitting unit in the thickness direction of the substrate, a first insulating layer on the encapsulation layer and including a first hole penetrating the first insulating layer and exposing the first reflection pattern, and a first color pattern at least partially in the first hole and on the first reflection pattern exposed by the first hole.

## Description

### CROSS-REFERENCE TO RELATED APPLICATIONS

This application claims the benefit of Korean Patent Application No. 10-2025-0028968, filed on March 06, 2025 in the Korean Intellectual Property Office, and Korean Patent Application No. 10-2025-0061232, filed on May 12, 2025 in the Korean Intellectual Property Office.

### BACKGROUND

### 1. Field

The present inventive concepts relate to display devices and electronic devices including the same.

### 2. Description of the Related Art

As the information society develops, demands for display devices for displaying images are increasing in various forms. The display devices may be flat panel display devices such as liquid crystal display devices, field emission display devices, and light emitting display devices. The light emitting display devices may include at least one of an organic light emitting display device including an organic light emitting element, an inorganic light emitting display device including an inorganic light emitting element such as an inorganic semiconductor, or an ultrasmall light emitting display device including an ultrasmall light emitting element.

Since the organic light emitting display device including the organic light emitting element does not need a light source such as a backlight unit, it is low in power consumption, can be made lightweight and thin, and has a wide viewing angle, high luminance and contrast, and fast response speed. Due to these high-quality characteristics, the organic emitting display device is drawing attention as a next-generation display device.

The organic light emitting display device may include a polarizing plate to prevent a decrease in the visibility of a displayed image due to reflection of external light. However, an output ratio of light emitted from the organic light emitting element may be reduced by the polarizing plate. If a color filter is applied instead of the polarizing plate, the output ratio of the light emitted from the organic light emitting element may increase, but reflectance due to external light may also increase.

### SUMMARY

Aspects of the present inventive concepts provide a display device having a high output ratio of light emitted from an organic light emitting element and low reflectance of external light.

However, aspects of the present inventive concepts are not restricted to the one set forth herein. The above and other aspects of the present inventive concepts will become more apparent to one of ordinary skill in the art to which the present inventive concepts pertain by referencing the detailed description of the present inventive concepts given below.

According to some example embodiments of the present inventive concepts, a display device may include a substrate, a first light emitting unit on the substrate and configured to emit light of a first wavelength band, a second light emitting unit on the substrate and configured to emit light of a second wavelength band, a third light emitting unit on the substrate and configured to emit light of a third wavelength band, an encapsulation layer on the first light emitting unit, the second light emitting unit, and the third light emitting unit, a first color filter on the encapsulation layer, overlapping the first light emitting unit in a thickness direction of the substrate, and configured to selectively transmit the light of the first wavelength band, a second color filter on the encapsulation layer, overlapping the second light emitting unit in the thickness direction of the substrate, and configured to selectively transmit the light of the second wavelength band, a third color filter on the encapsulation layer, overlapping the third light emitting unit in the thickness direction of the substrate, and configured to selectively transmit the light of the third wavelength band, a first reflection pattern on the encapsulation layer and overlapping the first light emitting unit in the thickness direction of the substrate, a first insulating layer on the encapsulation layer and including a first hole penetrating the first insulating layer and exposing the first reflection pattern, a first color pattern at least partially in the first hole and on the first reflection pattern exposed by the first hole.

The first color pattern may contact the first reflection pattern.

The first color pattern may contact the first color filter.

An angle defined by a side surface of the first color pattern and a lower surface of the first insulating layer may be in a range of 10 degrees to 90 degrees.

The display device may further include a second insulating layer on the encapsulation layer, and a touch sensor electrode on the second insulating layer.

The first reflection pattern may include the same material as the touch sensor electrode.

The first color pattern may be on the second insulating layer, and the first insulating layer may be on the touch sensor electrode.

The display device may further include a light blocking layer overlapping the touch sensor electrode in the thickness direction of the substrate and on the first insulating layer.

A thickness of the first color pattern may be greater than a thickness of the light blocking layer.

The light blocking layer may include a first sub-light blocking layer extending from the first color filter, a second sub-light blocking layer extending from the second color filter, and a third sub-light blocking layer extending from the third color filter, wherein the first sub-light blocking layer, the second sub-light blocking layer, and the third sub-light blocking layer overlap each other in the thickness direction of the substrate.

The third sub-light blocking layer may be at least partially in a hole penetrating the first insulating layer such that the third sub-light blocking layer contacts the touch sensor electrode.

The light of the first wavelength band may be light of a red wavelength band, the light of the second wavelength band is light of a green wavelength band, and the light of the third wavelength band is light of a blue wavelength band.

The third sub-light blocking layer may include the same material as the first color pattern.

The display device may further including a second reflection pattern on the encapsulation layer and overlapping the second light emitting unit in the thickness direction of the substrate wherein the first insulating layer includes a second hole penetrating the first insulating layer and exposing the second reflection pattern, and a second color pattern at least partially in the second hole and on the second reflection pattern exposed by the second hole.

The third color filter, the first color pattern, and the second color pattern may include the same material.

The display device may further include a third reflection pattern on the encapsulation layer and overlapping the third light emitting unit in the thickness direction of the substrate wherein the first insulating layer includes a third hole penetrating the first insulating layer and exposing the third reflection pattern, and a third color pattern at least partially in the third hole.

The touch sensor electrode may include a touch driving electrode and a touch sensing electrode, and the display device may include a touch driver electrically connected to the touch driving electrode and the touch sensing electrode, wherein the touch driver may be configured to detect the amount of change in capacitance formed between the touch driving electrode and the touch sensing electrode.

The first color pattern may include a (1-1)-th color pattern and a (1-2)-th color pattern, the (1-1)-th color pattern is in the first hole, the (1-2)-th color pattern is on the (1-1)-th color pattern, the (1-1)-th color pattern is configured to selectively transmit any one of the light of the second wavelength band or the light of the third wavelength band, the (1-2)-th color pattern is configured to selectively transmit the other of the light of the second wavelength band or the light of the third wavelength band, the second color pattern comprises a (2-1)-th color pattern and a (2-2)-th color pattern, the (2-1)-th color pattern is in the second hole, the (2-2)-th color pattern is on the (2-1)-th color pattern, the (2-1)-th color pattern is configured to selectively transmit any one of the light of the first wavelength band or the light of the third wavelength band, and the (2-2)-th color pattern is configured to selectively transmit the other of the light of the first wavelength band or the light of the third wavelength band.

The display device may further include a third reflection pattern on the encapsulation layer and overlapping the third light emitting unit in the thickness direction of the substrate wherein the first insulating layer includes a third hole penetrating the first insulating layer and exposing the third reflection pattern, a (3-1)-th color pattern located in the third hole and a (3-2)-th color pattern located on the (3-1)-th color pattern, wherein the (3-1)-th color pattern is configured to selectively transmit any one of the light of the first wavelength band or the light of the second wavelength band, and the (3-2)-th color pattern is configured to selectively transmit the other of the light of the first wavelength band or the light of the second wavelength band.

According to some example embodiments of the present inventive concepts, an electronic device may include a display module configured to display an image and a processor configured to transmit an image data signal to the display module. The display module may include a substrate, a first light emitting unit on the substrate and configured to emit light of a first wavelength band, a second light emitting unit on the substrate and configured to emit light of a second wavelength band, a third light emitting unit on the substrate and configured to emit light of a third wavelength band, an encapsulation layer on the first light emitting unit, the second light emitting unit, and the third light emitting unit, a first color filter on the encapsulation layer, overlapping the first light emitting unit in a thickness direction of the substrate, and configured to selectively transmit the light of the first wavelength band, a second color filter on the encapsulation layer, overlapping the second light emitting unit in the thickness direction of the substrate, and configured to selectively transmit the light of the second wavelength band, a third color filter on the encapsulation layer, overlapping the third light emitting unit in the thickness direction of the substrate, and configured to selectively transmit the light of the third wavelength band, a first reflection pattern on the encapsulation layer and overlapping the first light emitting unit in the thickness direction of the substrate, a first insulating layer on the encapsulation layer, the first insulating layer including a first hole penetrating the first insulating layer and exposing the first reflection pattern, and a first color pattern at least partially in the first hole and on the first reflection pattern exposed by the first hole.

According to an aspect, there is provided a display device as set out in claim 1. Additional features are set out in claims 2 to 14. According to an aspect, there is provided an electronic device as set out in claim 15.

A display device and an electronic device including the same according to some example embodiments may include a reflection pattern overlapping a light emitting element in a thickness direction and a color pattern located on the reflection pattern. Accordingly, the reflection pattern may reduce, minimize, or prevent a reduction in a light output ratio by reflecting and re-reflecting light emitted from the light emitting element (which may cause such emitted light to avoid absorption by the color pattern) to thereby improve image display performance by the display device, and the color pattern may reduce reflectance due to external light to improve displayed image visibility and thus further improve image display performance by the display device.

The color pattern may be at least partially located in a hole which penetrates an insulating layer and exposes the reflection pattern. Therefore, a difference between a height from an upper surface of the insulating layer to an upper surface of a light blocking layer and a height from the upper surface of the insulating layer to an upper surface of the color pattern may be reduced. Accordingly, the surface may become even or substantially even (e.g., planar), thus reducing reflectance due to external light and thus improving visibility of images displayed by the display device.

However, the effects of the present inventive concepts are not restricted to those set forth herein. The above and other effects of the present inventive concepts will become more apparent to one of daily skill in the art to which the present inventive concepts pertain by referencing the detailed description of the present inventive concepts given below.

### BRIEF DESCRIPTION OF THE DRAWINGS

These and/or other aspects will become apparent and more readily appreciated from the following description of some example embodiments, taken in conjunction with the accompanying drawings in which:
FIG. 1 is a perspective view of a display device according to some example embodiments;
FIG. 2 is a side view of the display device illustrated in FIG. 1 according to some example embodiments;
FIG. 3 is a plan view of a display layer of the display device illustrated in FIG. 1 according to some example embodiments;
FIG. 4 is a schematic layout view of an example of a touch sensing layer of the display device illustrated in FIG. 2 according to some example embodiments;
FIG. 5 is a schematic layout view of a part of a display area according to some example embodiments;
FIG. 6 is a cross-sectional view of an example of a display panel taken along line X1-X1' of FIG. 5 according to some example embodiments;
FIG. 7 is an enlarged cross-sectional view illustrating area A1 of FIG. 6 in detail according to some example embodiments;
FIGS. 8, 9, 10, 11, 12, 13, and 14 are cross-sectional views of examples of the display panel taken along line X1-X1' of FIG. 5 according to some example embodiments;
FIG. 15 is a block diagram of an electronic device according to some example embodiments; and
FIG. 16 is a schematic diagram of electronic devices according to some example embodiments.

### DETAILED DESCRIPTION

The inventive concepts will now be described more fully hereinafter with reference to the accompanying drawings, in which various embodiments of the inventive concepts are shown. The inventive concepts may, however, be embodied in different forms and should not be construed as limited to the embodiments set forth herein. Rather, these embodiments are provided so that this inventive concepts will be thorough and complete, and will fully convey the scope of the inventive concepts to those skilled in the art. The same reference numbers indicate the same components throughout the specification. In the attached drawing figures, the thickness of layers and regions is exaggerated for clarity.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

It will also be understood that when a layer is referred to as being "on" another layer or substrate, it can be directly on the other layer or substrate, or intervening layers may also be present. In contrast, when an element is referred to as being "directly on" another element, there are no intervening elements present. When an element is in "contact" with another element, the element may interchangeably be referred as being in "direct contact" with the other element.

The terminology used herein is for the purpose of describing particular embodiments only and is not intended to be limiting. As used herein, the singular forms "a," "an," and "the" are intended to include the plural forms, including "at least one," unless the content clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." "At least one of A and B" or "at least one selected from A and B" means "A and/or B." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

It will be understood that elements and/or properties thereof (e.g., structures, surfaces, directions, or the like), which may be referred to as being "perpendicular," "parallel," or the like with regard to other elements and/or properties thereof (e.g., structures, surfaces, directions, or the like) may be "perpendicular," "parallel," or the like or may be "substantially perpendicular," "substantially parallel," or the like, respectively, with regard to the other elements and/or properties thereof.

Elements and/or properties thereof (e.g., structures, surfaces, directions, or the like) that are "substantially perpendicular" or "substantially parallel" with regard to other elements and/or properties thereof will be understood to be "perpendicular" or "parallel", respectively, with regard to the other elements and/or properties thereof within manufacturing tolerances and/or material tolerances and/or have a deviation in magnitude and/or angle from "perpendicular" or "parallel", respectively, with regard to the other elements and/or properties thereof that is equal to or less than 10% (e.g., a. tolerance of ±10%).

It will be understood that elements and/or properties thereof may be recited herein as being "the same" as other elements and/or properties thereof, and it will be further understood that elements and/or properties thereof recited herein as being "the same" as other elements and/or properties thereof may be "the same" as or "substantially the same" as the other elements and/or properties thereof. Elements and/or properties thereof that are "substantially the same" as other elements and/or properties thereof will be understood to include elements and/or properties thereof that are the same as the other elements and/or properties thereof within manufacturing tolerances and/or material tolerances. Elements and/or properties thereof that are the same or substantially the same as other elements and/or properties thereof may be structurally the same or substantially the same, functionally the same or substantially the same, and/or compositionally the same or substantially the same.

While the term "same" may be used in description of some example embodiments, it should be understood that some imprecisions may exist. Thus, when one element or property is referred to as being the same as another element or property, it should be understood that the element or property is the same as another element or property within a desired manufacturing or operational tolerance range (e.g., ±10%).

It will be understood that elements and/or properties thereof described herein as being "substantially" the same as one or more other elements and/or properties thereof encompasses elements and/or properties thereof that have a relative difference in magnitude with the one or more other elements and/or properties thereof that is equal to or less than 10%. Further, regardless of whether elements and/or properties thereof are modified as "substantially," it will be understood that these elements and/or properties thereof should be construed as including a manufacturing or operational tolerance (e.g., ±10%) around the stated elements and/or properties thereof.

When the terms "about" or "substantially" are used in this specification in connection with a numerical value, it is intended that the associated numerical value includes a manufacturing or operational tolerance (e.g., ±10%) around the stated numerical value. Moreover, when the words "about" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system).

As described herein, when an operation is described to be performed, or an effect such as a structure is described to be established "by" or "through" performing additional operations, it will be understood that the operation may be performed and/or the effect/structure may be established "based on" the additional operations, which may include performing said additional operations alone or in combination with other further additional operations.

As described herein, an element that is described to be "spaced apart" from another element, in general and/or in a particular direction (e.g., vertically spaced apart, laterally spaced apart, etc.) and/or described to be "separated from" the other element, may be understood to be isolated from direct contact with the other element, in general and/or in the particular direction (e.g., isolated from direct contact with the other element in a vertical direction, isolated from direct contact with the other element in a lateral or horizontal direction, etc.). Similarly, elements that are described to be "spaced apart" from each other, in general and/or in a particular direction (e.g., vertically spaced apart, laterally spaced apart, etc.) and/or are described to be "separated" from each other, may be understood to be isolated from direct contact with each other, in general and/or in the particular direction (e.g., isolated from direct contact with each other in a vertical direction, isolated from direct contact with each other in a lateral or horizontal direction, etc.). Similarly, a structure described herein to be between two other structures to separate the two other structures from each other may be understood to be configured to isolate the two other structures from direct contact with each other.

Unless otherwise defined, all terms (including technical and scientific terms) used herein have the same meaning as commonly understood by one of ordinary skill in the art to which this inventive concepts belong. It will be further understood that terms, such as those defined in commonly used dictionaries, should be interpreted as having a meaning that is consistent with their meaning in the context of the relevant art and the inventive concepts, and will not be interpreted in an idealized or overly formal sense unless expressly so defined herein.

Some example embodiments are described herein with reference to cross section illustrations that are schematic illustrations of idealized example embodiments. As such, variations from the shapes of the illustrations as a result, for example, of manufacturing techniques and/or tolerances, are to be expected. Thus, example embodiments described herein should not be construed as limited to the particular shapes of regions as illustrated herein but are to include deviations in shapes that result, for example, from manufacturing. A region illustrated or described as flat may, typically, have rough and/or nonlinear features, for example. Moreover, sharp angles that are illustrated may be rounded. Thus, the regions illustrated in the drawing figures are schematic in nature and their shapes are not intended to illustrate the precise shape of a region and are not intended to limit the scope of the present claims.

Hereinafter, some example embodiments of the inventive concepts will be described in detail with reference to the accompanying drawings.

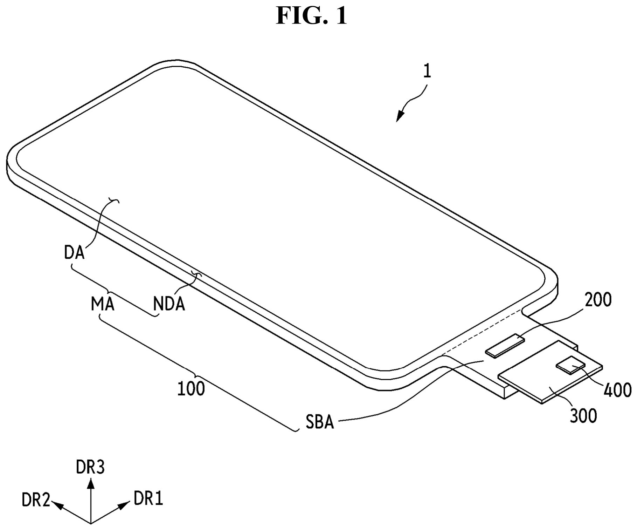

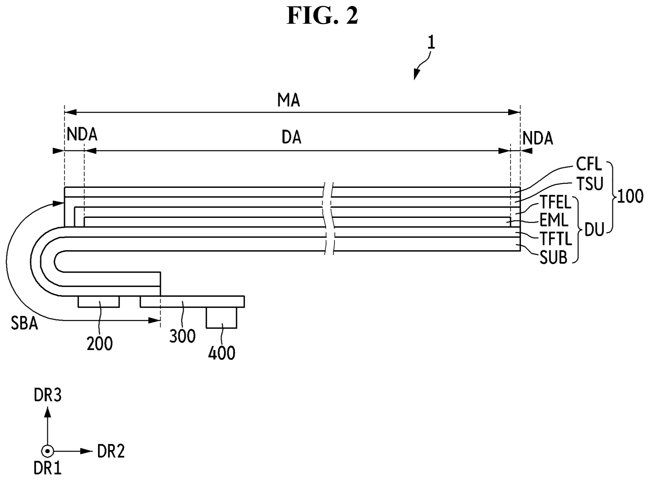

FIG. 1 is a perspective view of a display device 1 according to some example embodiments. FIG. 2 is a side view of the display device 1 illustrated in FIG. 1 according to some example embodiments.

Referring to FIGS. 1 and 2, the display device 1 according to some example embodiments may be applied to (e.g., included in) each of various portable electronic devices such as mobile phones, smartphones, tablet personal computers (PCs), mobile communication terminals, electronic notebooks, electronic books, portable multimedia players (PMPs), navigation devices, and ultra-mobile PCs (UMPCs). In some example embodiments, the display device 1 according to some example embodiments may be applied as a display unit of a television, a laptop computer, a monitor, a billboard, or an Internet of things (IoT) device. In some example embodiments, the display device 1 according to some example embodiments may be applied to wearable devices such as smart watches, watch phones, glasses-type displays, and head-mounted displays (HMDs). In some example embodiments, the display device 1 according to some example embodiments may be applied to an instrument cluster of a vehicle, a center fascia of a vehicle, a center information display (CID) placed on a dashboard of a vehicle, or a display placed on the back of a front seat as an entertainment for rear-seat passengers of a vehicle.

The display device 1 may be a light emitting display device such as an organic light emitting display device using an organic light emitting diode, a quantum dot light emitting display device including a quantum dot light emitting layer, an inorganic light emitting display device including an inorganic semiconductor, or an ultrasmall light emitting display device including an ultrasmall light emitting diode (a micro- or nano-light emitting diode). A case where the display device 1 is an organic light emitting display device will be mainly described below, but the embodiments are not limited thereto.

The display device 1 includes a display panel 100, a display driver 200, a display circuit board 300, and a touch driver 400.

The display panel 100 may be shaped like a rectangular plane having short sides in a first direction DR1 and long sides in a second direction DR2 intersecting the first direction DR1. Each corner where a short side extending in the first direction DR1 meets a long side extending in the second direction DR2 may be rounded to have a selected curvature or may be right-angled. The planar shape of the display panel 100 is not limited to a quadrangular shape but may also be other polygonal shapes, a circular shape, or an oval shape. The display panel 100 may be formed flat, but the embodiments are not limited thereto. For example, the display panel 100 may include a curved portion formed at left and right ends and having a constant or varying curvature. In addition, the display panel 100 may be formed to be flexible so that it can be curved, bent, folded, or rolled.

The display panel 100 includes a main area MA and a sub-area SBA.

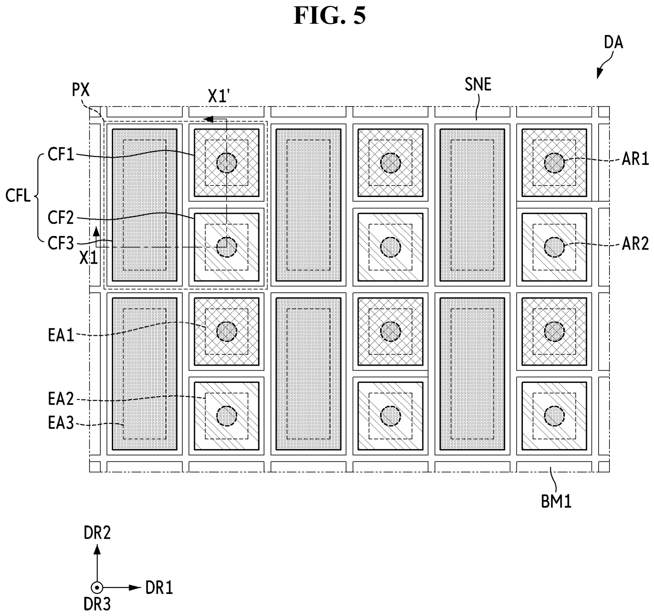

The main area MA includes a display area DA configured to display an image and a non-display area NDA located around the display area DA. The display area DA includes pixels PX (see FIG. 5) which display an image. The sub-area SBA may protrude from a side of the main area MA in the second direction DR2.

Although the sub-area SBA is unfolded in FIG. 1, it may also be bent as illustrated in FIG. 2. In this case, the sub-area SBA may be placed on a lower surface of the display panel 100. When the sub-area SBA is bent, it may be overlapped by the main area MA in a third direction DR3 which is a thickness direction of a substrate SUB. The display driver 200 may be placed in the sub-area SBA.

As illustrated in FIG. 2, the display panel 100 may include a display layer DU, a touch sensing layer TSU, and a color filter layer CFL. The display layer DU may include the substrate SUB, a thin-film transistor layer TFTL, a light emitting element layer EML, and an encapsulation layer TFEL.

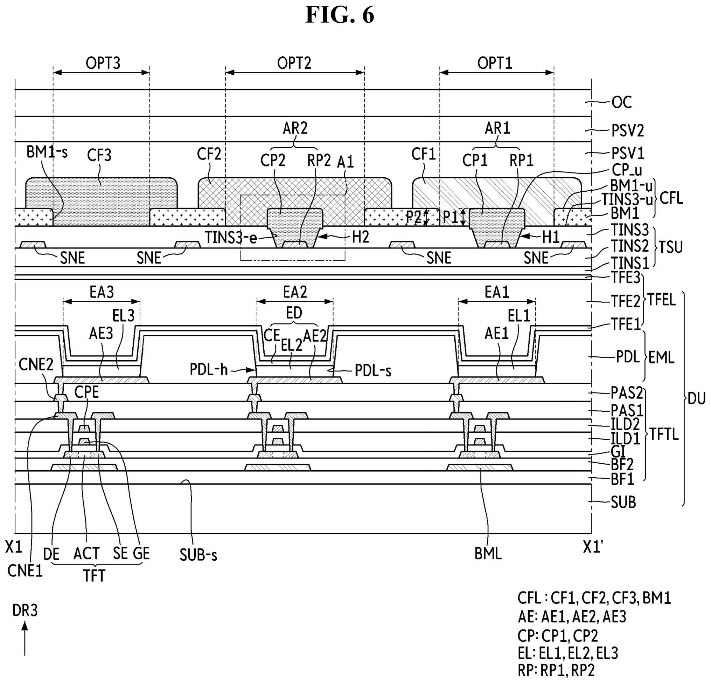

The thin-film transistor layer TFTL may be located on the substrate SUB. The thin-film transistor layer TFTL may be located in the main area MA and the sub-area SBA. The thin-film transistor layer TFTL includes thin-film transistors TFT (see FIG. 6).

The light emitting element layer EML may be located on the thin-film transistor layer TFTL. The light emitting element layer EML may be located in the display area DA of the main area MA. The light emitting element layer EML includes light emitting elements located in light emitting units.

The encapsulation layer TFEL may be located on the light emitting element layer EML. The encapsulation layer TFEL may be located in the display area DA and the non-display area NDA of the main area MA. The encapsulation layer TFEL includes at least one inorganic layer and at least one organic layer to encapsulate the light emitting element layer EML.

The touch sensing layer TSU may be located on the encapsulation layer TFEL. The touch sensing layer TSU may be located in the display area DA and the non-display area NDA of the main area MA. The touch sensing layer TSU may sense a touch of a person or object using sensor electrodes.

The color filter layer CFL may be located on the touch sensing layer TSU. The color filter layer CFL may be located in the display area DA and the non-display area NDA of the main area MA. The color filter layer CFL may be an anti-reflection member for reducing the reflection of external light from metal lines and metal electrodes of the display panel 100. The color filter layer CFL includes a plurality of color filters. For example, the color filter layer CFL may include a first color filter that transmits light in a first wavelength range, a second color filter that transmits light in a second wavelength range, and a third color filter that transmits light in a third wavelength range.

A cover window may be located on the touch sensing layer TSU to protect an upper portion of the display panel 100. The cover window may be attached onto the touch sensing layer TSU by a transparent adhesive member such as an optically clear adhesive (OCA) film or an optically clear resin (OCR). The cover window may be an inorganic material such as glass or may be an organic material such as plastic or a polymer material.

The display driver 200 may generate signals and voltages for driving the display panel 100. The display driver 200 may be formed as an integrated circuit and attached onto the display panel 100 using a chip-on-glass (COG) method, a chip-on-plastic (COP) method, or an ultrasonic bonding method. However, embodiments are not limited to these methods. For example, the display driver 200 may also be attached onto the display circuit board 300 using a chip-on-film (COF) method.

The display circuit board 300 may be attached to an end of the sub-area SBA of the display panel 100. Accordingly, the display circuit board 300 may be electrically connected to the display panel 100 and the display driver 200. The display panel 100 and the display driver 200 may receive digital video data, timing signals, and driving voltages through the display circuit board 300. The display circuit board 300 may be a flexible printed circuit board, a printed circuit board, or a flexible film such as a chip-on-film.

The touch driver 400 may be located on the display circuit board 300. The touch driver 400 may be formed as an integrated circuit and attached onto the display circuit board 300.

The touch driver 400 may be electrically connected to the sensor electrodes of the touch sensing layer TSU of the display panel 100. The touch driver 400 applies driving signals to the sensor electrodes of the touch sensing layer TSU and measures mutual capacitance values of the sensor electrodes. Each of the driving signals may be a signal having a plurality of driving pulses. The touch driver 400 may determine whether a user's touch or proximity has occurred based on the mutual capacitance values. The user's touch indicates that the user's finger or an object, such as a pen, directly touches a surface of the display device 1 located on the touch sensing layer TSU. The user's proximity indicates that the user's finger or an object, such as a pen, hovers above the surface of the display device 1.

As illustrated in FIGS. 1 and 2, the display panel 100 includes the color filter layer CFL including color filters in order to reduce the reflection of external light by the metal lines and metal electrodes of the display panel 100. Therefore, there is no need to attach a separate anti-reflection member, such as a polarizing plate, onto the display panel 100. Accordingly, the manufacturing cost of the display device 1 can be reduced.

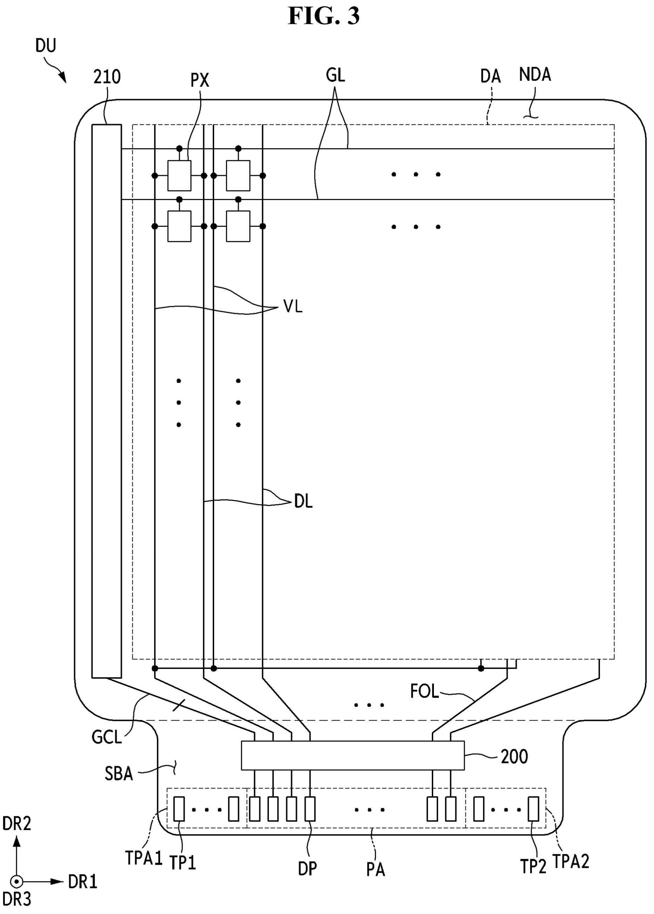

FIG. 3 is a plan view of the display layer DU of the display device 1 illustrated in FIG. 1 according to some example embodiments.

Referring to FIG. 3, the display layer DU may include the display area DA and the non-display area NDA.

The display area DA may be located in the center of the display panel 100. A plurality of pixels PX, a plurality of gate lines GL, a plurality of data lines DL, and a plurality of power lines VL may be located in the display area DA. Each of the pixels PX may be defined as a smallest unit that emits light.

The gate lines GL may supply gate signals received from a gate driver 210 to the pixels PX. The gate lines GL may extend in the first direction DR1 and may be spaced apart from each other in the second direction DR2 intersecting the first direction DR1.

The display device 1 according to some example embodiments may further include emission lines that provide a voltage required for light emission of each pixel PX. The emission lines may extend in the first direction DR1 and may be spaced apart from each other in the second direction DR2 intersecting the first direction DR1. The emission lines may supply emission signals received from the gate driver 210 to the pixels PX.

The data lines DL may supply data voltages received from the display driver 200 to the pixels PX. The data lines DL may extend in the second direction DR2 and may be spaced apart from each other in the first direction DR1.

The power lines VL may supply a power supply voltage received from the display driver 200 to the pixels PX. Here, the power supply voltage may be at least one of a driving voltage, an initialization voltage, a reference voltage, or a low-potential voltage. The power lines VL may extend in the second direction DR2 and may be spaced apart from each other in the first direction DR1.

The non-display area NDA may surround the display area DA. In the non-display area NDA, the gate driver 210, fan-out lines FOL, and gate control lines GCL may be located. The gate driver 210 may generate a plurality of gate signals based on a gate control signal and may sequentially supply the gate signals to the gate lines GL in a set order.

The fan-out lines FOL may extend from the display driver 200 to the display area DA. The fan-out lines FOL may supply data voltages received from the display driver 200 to the data lines DL.

The gate control lines GCL may extend from the display driver 200 to the gate driver 210. The gate control lines GCL may supply a gate control signal received from the display driver 200 to the gate driver 210.

The sub-area SBA may include the display driver 200, a pad area PA, and first and second touch pad areas TPA1 and TPA2.

The display driver 200 may output signals and voltages for driving the display panel 100 to the fan-out lines FOL. The display driver 200 may supply data voltages to the data lines DL through the fan-out lines FOL. The data voltages may be supplied to the pixels PX and may control respective luminance (e.g., brightness) of the pixels PX. The display driver 200 may supply a gate control signal to the gate driver 210 through the gate control lines GCL.

The pad area PA, the first touch pad area TPA1, and the second touch pad area TPA2 may be located at an edge of the sub-area SBA. The pad area PA, the first touch pad area TPA1, and the second touch pad area TPA2 may be electrically connected to the display circuit board 300 using a material such as an anisotropic conductive film or self-assembly anisotropic conductive paste (SAP).

The pad area PA may include a plurality of display pad units DP. The display pad units DP may be connected to a graphic system through the display circuit board 300. The display pad units DP may be connected to the display circuit board 300 to receive digital video data and may supply the digital video data to the display driver 200.

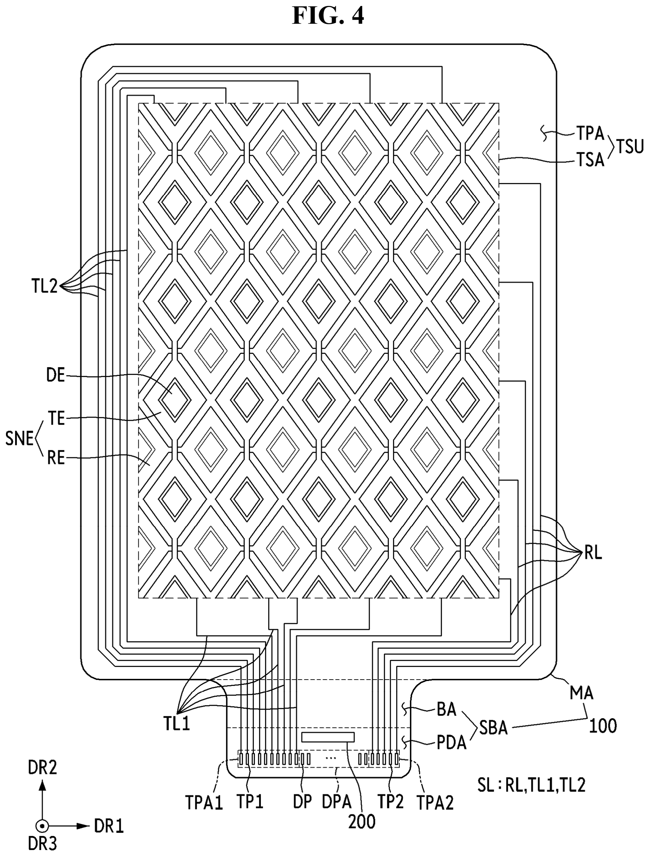

FIG. 4 is a schematic layout view of an example of the touch sensing layer TSU of the display device 1 illustrated in FIG. 2 according to some example embodiments.

In FIG. 4, a case where sensor electrodes SNE of the touch sensing layer TSU, also referred to herein as touch sensor electrodes, include two types of electrodes, for example, driving electrodes TE (also referred to herein as touch driving electrodes) and sensing electrodes RE (also referred to herein as touch sensing electrodes) and are driven in a mutual capacitance manner in which driving signals are applied to the driving electrodes TE and then voltages charged in mutual capacitance are sensed through the sensing electrodes RE will be mainly described, but embodiments are not limited thereto.

In FIG. 4, only the sensor electrodes SNE, dummy patterns DE, sensor lines (TL1, TL2, RL), and sensor pads TP1 and TP2 are illustrated for ease of description.

Referring to FIG. 4, the touch sensing layer TSU includes a touch sensor area TSA for sensing a user's touch and a touch peripheral area TPA located around the touch sensor area TSA. The touch sensor area TSA may overlap the display area DA of FIGS. 1 through 3, and the touch peripheral area TPA may overlap the non-display area NDA of FIGS. 1 through 3.

The touch sensor area TSA includes the sensor electrodes SNE and the dummy patterns DE. The sensor electrodes SNE may include the driving electrodes TE and the sensing electrode RE. The driving electrodes TE and the sensing electrodes RE may be electrodes for forming mutual capacitance to sense a touch of an object or a person.

The sensing electrodes RE may be arranged side by side in the first direction DR1 and the second direction DR2. The sensing electrodes RE may include multiple sets of sensing electrodes RE where each set of sensing electrodes RE may be electrically connected to each other in the first direction DR1. The sensing electrodes RE adjacent to each other in the first direction DR1 may be connected to each other. The sensing electrodes RE adjacent to each other in the second direction DR2 may be electrically isolated from each other.

The driving electrodes TE may be arranged side by side in the first direction DR1 and the second direction DR2. The driving electrodes TE adjacent to each other in the first direction DR1 may be electrically isolated from each other. The driving electrodes TE may include multiple sets of driving electrodes TE where each set of driving electrodes TE may be electrically connected to each other in the second direction DR2. For example, the driving electrodes TE adjacent to each other in the second direction DR2 may be connected to each other through a connection electrode.

Each of the dummy patterns DE may be surrounded by a driving electrode TE or a sensing electrode RE. Each of the dummy patterns DE may be electrically isolated from the driving electrode TE or the sensing electrode RE. Each of the dummy patterns DE may be spaced apart from the driving electrode TE or the sensing electrode RE. Each of the dummy patterns DE may electrically float.

In FIG. 4, each of the driving electrodes TE, the sensing electrodes RE, and the dummy patterns DE has a rhombic planar shape. However, embodiments are not limited to a rhombic planar shape. For example, each of the driving electrodes TE, the sensing electrodes RE, and the dummy patterns DE may also be shaped like a quadrangle other than a rhombus, a polygon other than a quadrangle, a circle, or an oval in plan view.

The sensor lines (TL1, TL2, RL) may be located in the sensor peripheral area TPA. The sensor lines (TL1, TL2, RL) include sensing lines RL connected to the sensing electrodes RE and first driving lines TL1 and second driving lines TL2 connected to the driving electrodes TE.

The sensing electrodes RE located at one side of the touch sensor area TSA may be connected one-to-one to the sensing lines RL. For example, as illustrated in FIG. 4, rightmost sensing electrodes RE among the sensing electrodes RE electrically connected to each other in the first direction DR1 may be connected to the sensing lines RL. The sensing lines RL may be connected one-to-one to second sensor pads TP2. Therefore, the touch driver 400 may be electrically connected to the sensing electrodes RE (e.g., the touch sensing electrodes).

The driving electrodes TE located at one side of the touch sensor area TSA may be connected one-to-one to the first driving lines TL1, and the driving electrodes TE located at the other side of the touch sensor area TSA may be connected one-to-one to the second driving lines TL2. For example, as illustrated in FIG. 4, lowermost driving electrodes TE among the driving electrodes TE electrically connected to each other in the second direction DR2 may be connected to the first driving lines TL1, and uppermost driving electrodes TE may be connected to the second driving lines TL2. The second driving lines TL2 may pass outside a left side of the touch sensor area TSA and then may be connected to the driving electrodes TE at an upper side of the touch sensor area TSA.

The first driving lines TL1 and the second driving lines TL2 may be connected one-to-one to first sensor pads TP1. Therefore, the touch driver 400 may be electrically connected to the driving electrodes TE (e.g., touch driving electrodes). The driving electrodes TE are connected to the driving lines TL1 and TL2 at opposite sides of the touch sensor area TSA to receive touch driving signals. Therefore, it is possible to reduce, minimize, or prevent a difference between touch driving signals applied to the driving electrodes TE at a lower side of the touch sensor area TSA from occurring due to the resistive-capacitive (RC) delay of the touch driving signals.

The first sensor pad area TPA1 where the first sensor pads TP1 are placed may be located on one side of a display pad area DPA where display pads DP are placed. The second sensor pad area TPA2 where the second sensor pads TP2 are placed may be located on the other side of the display pad area DPA. The display pads DP may be electrically connected to the data lines of the display panel 100.

The display pad area DPA, the first sensor pad area TPA1, and the second sensor pad area TPA2 may correspond to the pads of the display panel 100 connected to the display circuit board 300 illustrated in FIG. 1. The display circuit board 300 may be placed on the display pads DP, the first sensor pads TP1, and the second sensor pads TP2. The display pads DP, the first sensor pads TP1, and the second sensor pads TP2 may be electrically connected to the display circuit board 300 using a low-resistance, high-reliability material such as an anisotropic conductive film or SAP. Therefore, the display pads DP, the first sensor pads TP1, and the second sensor pads TP2 may be electrically connected to the touch driver 400 placed on the display circuit board 300.

FIG. 5 is a schematic layout view of a part of a display area DA according to some example embodiments. Such a display area DA may be included in the display area DA of the display device 1 such as illustrated in FIGS. 1 to 3, according to some example embodiments.

In FIG. 5, for ease of description, first light emitting units EA1, second light emitting units EA2 and third light emitting units EA3 are indicated by dotted lines, and first color filters CF1, second color filters CF2 and third color filters CF3 of the color filter layer CFL are indicated by solid lines.

Referring to FIG. 5, each pixel PX includes a first light emitting unit EA1 that emits first light, a second light emitting unit EA2 that emits second light, and a third light emitting unit EA3 that emits third light. For example, the first light is light in a red wavelength band, the second light is light in a green wavelength band, and the third light is light in a blue wavelength band. Wavelength bands may be referred to herein interchangeably as wavelength spectra.

The arrangement structure of the first through third light emitting units EA1 through EA3 in each pixel PX may be an S-stripe structure. For example, the third light emitting unit EA3 may be located in a first column, and the first light emitting unit EA1 and the second light emitting unit EA2 may be located in a second column adjacent to the first column. The third light emitting unit EA3 may be a quadrangle having long sides in the second direction DR2. The first light emitting unit EA1 and the second light emitting unit EA2 may be quadrangles. A side of each of the first light emitting unit EA1 and the second light emitting unit EA2 may face a long side of the third light emitting unit EA3. That is, the first light emitting unit EA1 and the second light emitting unit EA2 may neighbor each other in the second direction DR2, the first light emitting unit EA1 and the third light emitting unit EA3 may neighbor each other in the first direction DR1, and the second light emitting unit EA2 and the third light emitting unit EA3 may neighbor each other in the first direction DR1.

Although the first through third light emitting units EA1 through EA3 have a quadrangular planar shape in the example embodiments shown in FIG. 5, embodiments are not limited to a quadrangular planar shape. For example, each of the first through third light emitting units EA1 through EA3 may also have a polygonal shape other than a quadrangle, a circular shape, or an oval shape in plan view. In addition, the arrangement structure of the first through third light emitting units EA1 through EA3 may be a pentile structure. In FIG. 5, the area of the third light emitting unit EA3 is the largest, but embodiments are not limited thereto.

The first through third color filters CF1 through CF3 may overlap the first through third light emitting units EA1 through EA3, respectively, in plan view. For example, the first color filters CF1 may overlap the first light emitting units EA1 in plan view. The first color filters CF1 may not overlap (e.g., may be exposed from) the second light emitting units EA2 and the third light emitting units EA3 in plan view. The first color filters CF1 may transmit (e.g., selectively transmit) the first light and absorb and block the second light and the third light. Accordingly, the first light emitted from the first light emitting units EA1 may be output through the first color filters CF1. The second color filters CF2 may overlap the second light emitting units EA2 in plan view. The second color filters CF2 may not overlap (e.g., may be exposed from) the first light emitting units EA1 and the third light emitting units EA3 in plan view. The second color filters CF2 may transmit (e.g., selectively transmit) the second light and absorb and block the first light and the third light. Accordingly, the second light emitted from the second light emitting units EA2 may be output through the second color filters CF2. The third color filters CF3 may overlap the third light emitting units EA3 in plan view. The third color filters CF3 may not overlap (e.g., may be exposed from) the first light emitting units EA1 and the second light emitting units EA2 in plan view. The third color filters CF3 may transmit (e.g., selectively transmit) the third light and absorb and block the first light and the second light. Accordingly, the third light emitted from the third light emitting units EA3 may be output through the third color filters CF3. For example, in example embodiments where the first light emitting unit EA1 is configured to emit light of a first wavelength band, the first color filter CF1 may be configured to transmit (e.g., selectively transmit) the light of the first wavelength band. For example, in example embodiments where the second light emitting unit EA2 is configured to emit light of a second wavelength band, the second color filter CF2 may be configured to transmit (e.g., selectively transmit) the light of the second wavelength band. For example, in example embodiments where the third light emitting unit EA3 is configured to emit light of a third wavelength band, the third color filter CF3 may be configured to transmit (e.g., selectively transmit) the light of the third wavelength band. Where a color filter is described herein to "transmit" light of one or more particular wavelength bands, it will be understood that the color filter may be interchangeably referred to as "selectively" transmitting such light of such one or more particular wavelength bands.

As described herein, overlapping in plan view may be referred to interchangeably as overlapping in thickness direction of the substrate SUB. The thickness direction of the substrate SUB may be a direction extending perpendicular to an upper surface SUB-s of the substrate SUB and may be referred to interchangeably as a third direction DR3. Additionally, first and second directions DR1 and DR2 may be parallel to the upper surface SUB-s of the substrate SUB and may be perpendicular to the third direction DR3 and may be perpendicular to each other.

The color filters CF1 through CF3 may be formed wider than corresponding light emitting units EA1 through EA3 to entirely cover the corresponding light emitting units EA1 through EA3 in plan view (e.g., in the third direction DR3), respectively.

A first absorption-reflection pattern AR1 may be located at the center, in plan view (e.g., in a plane extending in the first and second directions DR1 and DR2), of each of the first color filters CF1 and the first light emitting units EA1, and a second absorption-reflection pattern AR2 may be located at the center, in plan view (e.g., in a plane extending in the first and second directions DR1 and DR2), of each of the second color filters CF2 and the second light emitting units EA2. The areas, in plan view (e.g., in a plane extending in the first and second directions DR1 and DR2), of the first absorption-reflection pattern AR1 and the second absorption-reflection pattern AR2 may be about 10% or less of the areas of each first light emitting unit EA1 and each second light emitting unit EA2, respectively. As the areas, in plan view (e.g., in a plane extending in the first and second directions DR1 and DR2), of the first absorption-reflection pattern AR1 and the second absorption-reflection pattern AR2 increase, an output ratio of light emitted from a light emitting layer decreases. In addition, as the areas, in plan view (e.g., in a plane extending in the first and second directions DR1 and DR2), of the first absorption-reflection pattern AR1 and the second absorption-reflection pattern AR2 decrease, the reflectance of external light by the absorption-reflection patterns and thus by the display device 1 increases. Therefore, the areas, in plan view (e.g., in a plane extending in the first and second directions DR1 and DR2), of the first absorption-reflection pattern AR1 and the second absorption-reflection pattern AR2 may be designed within an appropriate range in consideration of the above factors.

In some example embodiments, the first absorption-reflection pattern AR1 and the second absorption-reflection pattern AR2 are circular in plan view (e.g., in a plane extending in the first and second directions DR1 and DR2). However, embodiments are not limited to a circular shape. For example, the first absorption-reflection pattern AR1 and the second absorption-reflection pattern AR2 can have various shapes in plan view such as a quadrangular shape, a donut shape, and a cross shape.

Each of the absorption-reflection patterns AR1 and AR2 may include a reflection pattern RP (see FIG. 6) that reflects light emitted by a light emitting element ED (see FIG. 6) and a color pattern CP (see FIG. 6) that absorbs a portion of light incident from the outside. The color pattern CP (see FIG. 6), which is the same material as a third color filter CF3, may reduce reflectance of the display device 1 due to external light based on absorbing a portion of the second light and the third light passing through a first color filter CF1 among the light incident from the outside or a portion of the first light and the third light passing through a second color filter CF2 among the light incident from the outside.

When only the color pattern CP (see FIG. 6) is applied, a portion of the light emitted by the light emitting element ED (see FIG. 6) is absorbed by the color pattern CP (see FIG. 6). Accordingly, the output ratio of the light emitted by the light emitting element ED (see FIG. 6), and thus the output ratio of the display device 1, may be reduced. When the color pattern CP (see FIG. 6) and the reflection pattern RP are applied together, it is possible to reduce reflectance due to external light (e.g., reflectance of the display device 1 due to external light) while reducing, minimizing, or preventing a reduction in the output ratio of the light emitted by the light emitting element ED (e.g., output ratio of the display device 1) (see FIG. 6). The absorption-reflection patterns AR1 and AR2 will be described in detail later with reference to FIG. 6.

A first light blocking layer BM1 and a sensor electrode SNE may be located between the first through third light emitting units EA1 through EA3. The first light blocking layer BM1 and the sensor electrode SNE may overlap each other in plan view (e.g., in the third direction DR3). Accordingly, the first light blocking layer BM1 may reduce, minimize, or prevent reflection of external light due to the sensor electrode SNE. Since the sensor electrode SNE has a mesh structure or a net structure in plan view, it may surround the first light emitting units EA1, the second light emitting units EA2, and the third light emitting units EA3. That is, the first light blocking layer BM1 and the sensor electrode SNE may not overlap the light emitting units EA1 through EA3 of each pixel PX. Accordingly, light emitted from the light emitting units EA1 through EA3 can be prevented from being reduced in output ratio by being blocked by the first light blocking layer BM1 or the sensor electrode SNE, or such reduction may be reduced or minimized. Referring back to FIGS. 1 and 4, the sensor electrode SNE, also referred to herein as a touch sensor electrode, may include a driving electrode TE (also referred to herein as a touch driving electrode) and a sensing electrode RE (also referred to herein as a touch sensing electrode), and the touch driver 400 may be electrically coupled to the driving electrode TE and the sensing electrode RE and is configured to detect an amount of change in capacitance formed between the driving electrode TE and the sensing electrode RE.

The color filters CF1, CF2 and CF3 of the color filter layer CFL may partially overlap (e.g., in plan view, third direction DR3, etc.) the first light blocking layer BM1 and the sensor electrode SNE.

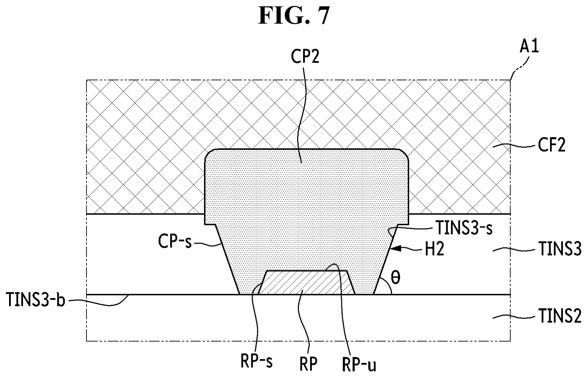

FIG. 6 is a cross-sectional view of an example of the display panel 100 taken along line X1-X1' of FIG. 5. FIG. 7 is an enlarged cross-sectional view illustrating some example embodiments of area A1 of FIG. 6 in detail.

Referring to FIGS. 6 and 7, the display panel 100 may include the display layer DU, the touch sensing layer TSU, the color filter layer CFL, a passivation layer PSV1 and a passivation layer PSV2, and an overcoat layer OC. The display layer DU may include the substrate SUB, the thin-film transistor layer TFTL, the light emitting element layer EML, and the encapsulation layer TFEL. The color filter layer CFL may include the first light blocking layer BM1 and the color filters CF1, CF2 and CF3.

The substrate SUB may be a base substrate or a base member. The substrate SUB may be a flexible substrate that can be bent, folded, rolled, etc. For example, the substrate SUB may include polymer resin such as polyimide (PI). However, embodiments are not limited to such an example. In some example embodiments, the substrate SUB may include a glass material or a metal material.

The thin-film transistor layer TFTL may include a first buffer layer BF1, bottom metal layers BML, a second buffer layer BF2, thin-film transistors TFT, a gate insulating layer GI, a first interlayer insulating layer ILD1, capacitor electrodes CPE, a second interlayer insulating layer ILD2, first connection electrodes CNE1, a first protective layer PAS1, second connection electrodes CNE2, and a second protective layer PAS2.

The first buffer layer BF1 may be located on the substrate SUB. The first buffer layer BF1 may include an inorganic layer that can reduce, minimize, or prevent the penetration of air or moisture. For example, the first buffer layer BF1 may include a plurality of inorganic layers stacked alternately.

The bottom metal layers BML may be located on the first buffer layer BF1. For example, each of the bottom metal layers BML may be a single layer or a multilayer including any one or more of molybdenum (Mo), aluminum (Al), chromium (Cr), gold (Au), titanium (Ti), nickel (Ni), neodymium (Nd), copper (Cu), or alloys thereof.

The second buffer layer BF2 may cover the first buffer layer BF1 and the bottom metal layers BML. The second buffer layer BF2 may include an inorganic layer that can prevent the penetration of air or moisture. For example, the second buffer layer BF2 may include a plurality of inorganic layers stacked alternately.

The thin-film transistors TFT may be located on the second buffer layer BF2 and may form respective pixel circuits of a plurality of pixels. For example, each of the thin-film transistors TFT may be a driving transistor or a switching transistor of a pixel circuit. Each of the thin-film transistors TFT may include a semiconductor layer ACT, a source electrode SE, a drain electrode DE, and a gate electrode GE.

The semiconductor layer ACT may be located on the second buffer layer BF2. The semiconductor layer ACT may overlap a bottom metal layer BML and the gate electrode GE in the thickness direction and may be insulated from the gate electrode GE by the gate insulating layer GI. In portions of the semiconductor layer ACT, the material of the semiconductor layer ACT may be made conductive to form the source electrode SE and the drain electrode DE.

The gate electrode GE may be located on the gate insulating layer GI. The gate electrode GE may overlap the semiconductor layer ACT with the gate insulating layer GI. The gate insulating layer GI may be located between the gate electrode GE and the semiconductor layer ACT.

The gate insulating layer GI may be located on the semiconductor layers ACT. For example, the gate insulating layer GI may cover the semiconductor layers ACT and the second buffer layer BF2 and may insulate the semiconductor layers ACT from the gate electrodes GE. The gate insulating layer GI may include contact holes through which the first connection electrodes CNE1 pass.

The first interlayer insulating layer ILD1 may cover the gate electrodes GE and the gate insulating layer GI. The first interlayer insulating layer ILD1 may include contact holes through which the first connection electrodes CNE1 pass. The contact holes of the first interlayer insulating layer ILD1 may be connected to the contact holes of the gate insulating layer GI and contact holes of the second interlayer insulating layer ILD2.

The capacitor electrodes CPE may be located on the first interlayer insulating layer ILD1. The capacitor electrodes CPE may overlap the gate electrodes GE in the thickness direction DR3. The capacitor electrodes CPE and the gate electrodes GE may form capacitances.

The second interlayer insulating layer ILD2 may cover the capacitor electrodes CPE and the first interlayer insulating layer ILD1. The second interlayer insulating layer ILD2 may include contact holes through which the first connection electrodes CNE1 pass. The contact holes of the second interlayer insulating layer ILD2 may be connected to the contact holes of the first interlayer insulating layer ILD1 and the contact holes of the gate insulating layer GI.

The first connection electrodes CNE1 may be located on the second interlayer insulating layer ILD2. The first connection electrodes CNE1 may electrically connect the drain electrodes DE of the thin-film transistors TFT to the second connection electrodes CNE2. The first connection electrodes CNE1 may be inserted into the contact holes formed in the second interlayer insulating layer ILD2, the first interlayer insulating layer ILD1, and the gate insulating layer GI to contact the drain electrodes DE of the thin-film transistors TFT.

The first protective layer PAS1 may cover the first connection electrodes CNE1 and the second interlayer insulating layer ILD2. The first protective layer PAS1 may protect the thin-film transistors TFT. The first protective layer PAS1 may include contact holes through which the second connection electrodes CNE2 pass.

The second connection electrodes CNE2 may be located on the first protective layer PAS1. The second connection electrodes CNE2 may electrically connect the first connection electrodes CNE1 to pixel electrodes AE of light emitting elements ED. The second connection electrodes CNE2 may be inserted into the contact holes formed in the first protective layer PAS1 to contact the first connection electrodes CNE1.

The second protective layer PAS2 may cover the second connection electrodes CNE2 and the first protective layer PAS1. The second protective layer PAS2 may include contact holes through which the pixel electrodes AE of the light emitting elements ED pass.

The light emitting element layer EML may be located on the thin-film transistor layer TFTL. The light emitting element layer EML may include the light emitting elements ED and a pixel defining layer PDL. Each of the light emitting elements ED may include a pixel electrode AE, a light emitting layer EL, and a common electrode CE.

The pixel electrode AE may be located on the second protective layer PAS2. Different pixel electrodes AE may overlap different openings of the pixel defining layer PDL, respectively. The pixel electrode AE may be electrically connected to the drain electrode DE of a thin-film transistor TFT through the first and second connection electrodes CNE1 and CNE2. In some example embodiments, the pixel electrode AE may be a reflective electrode, for example comprising a metal, molybdenum (Mo), titanium (Ti), copper (Cu), aluminum (Al) or indium tin oxide (ITO) or may be formed as a stacked structure (Ti/Al/Ti) of aluminum and titanium, a stacked structure (ITO/Al/ITO) of aluminum and indium tin oxide, an APC alloy, or a stacked structure (ITO/APC/ITO) of an APC alloy and indium tin oxide.

The light emitting layer EL may be located on the pixel electrode AE. For example, the light emitting layer EL may be, but is not limited to, an organic light emitting layer including an organic material. When the light emitting layer EL is an organic light emitting layer, if a corresponding thin-film transistor TFT applies a selected voltage to the pixel electrode AE of a corresponding light emitting element ED and the common electrode CE of the corresponding light emitting element ED receives a common voltage or a cathode voltage, holes and electrons may move to the light emitting layer EL through a hole transporting layer and an electron transporting layer, respectively. Then, the holes and the electrons may be combined with each other in the light emitting layer EL to emit light.

In some example embodiments, the light emitting layers EL respectively located on different pixel electrodes AE may emit light of different colors. For example, a light emitting layer EL located on a first pixel electrode AE1 may be a first light emitting layer EL1 and emit light of a first color which is red light, a light emitting layer EL located on a second pixel electrode AE2 may be a second light emitting layer EL2 and may emit light of a second color which is green light, and a light emitting layer EL located on a third pixel electrode AE3 may be a third light emitting layer EL3 and may emit light of a third color which is blue light. However, embodiments are not limited to such examples. In some example embodiments, the light emitting layers EL may be provided as one common layer on different pixel electrodes AE and the first pixel defining layer PDL, or the light emitting layer EL located on the different pixel electrodes AE may emit light of the same color. In this case, the display device 1 may further include a color adjustment layer located on the light emitting elements ED.

The common electrode CE may be located on the light emitting layers EL. For example, the common electrode CE may be implemented as an electrode common to all pixels without being separated for each pixel. The common electrode CE may be located on the light emitting layers EL on the pixel electrodes AE and may be located on the pixel defining layer PDL in an area excluding the pixel electrodes AE.

The common electrode CE may receive a common voltage or a low-potential voltage. When a pixel electrode AE receives a voltage corresponding to a data voltage and the common electrode CE receives a low-potential voltage, a potential difference may be formed between the pixel electrode AE and the common electrode CE. Accordingly, a light emitting layer EL may emit light.

The pixel defining layer PDL may include a plurality of openings and may be located on the second protective layer PAS2 and a portion of each of the pixel electrodes AE. Each of the openings of the pixel defining layer PDL may expose a portion of a pixel electrode AE. As described above, the openings of the pixel defining layer PDL may define first through third emission areas, respectively, and their areas or sizes may be different from each other. The pixel defining layer PDL may separate and insulate the respective pixel electrodes AE of the light emitting elements ED from each other. The pixel defining layer PDL may include a light absorbing material to prevent light reflection. For example, the pixel defining layer PDL may include a polyimide (PI)-based binder and a pigment in which red, green and blue are mixed. In some example embodiments, the pixel defining layer PDL may include a cardo-based binder resin and a mixture of a lactam black pigment and a blue pigment. In some example embodiments, the pixel defining layer PDL may include carbon black.

In some example embodiments, the first, second, and third light emitting units EA1, EA2, and EA3 may each be defined by a respective light emitting element ED, including a portion of a respective pixel electrode AE (a first pixel electrode AE1, a second pixel electrode AE2, or a third pixel electrode AE3, respectively) that is exposed by a hole PDL-h penetrating the pixel defining layer PDL (said hole PDL-h being defined by one or more inner surfaces PSL-s of the pixel defining layer PDL), a respective light emitting layer EL (e.g., a first light emitting layer EL1, a second light emitting layer EL2, or a third light emitting layer EL3, respectively) on the exposed portion of the respective pixel electrode AE in the hole PDL-h defined by the pixel defining layer PDL, and a respective portion of the common electrode CE overlapping the respective light emitting layer EL. In some example embodiments, the first to third light emitting layers EL1 to EL3 may be separate portions of a single light emitting layer EL that is a single unitary piece of material that may be configured to emit of a particular wavelength band. In some example embodiments, the first to third light emitting layers EL1 to EL3 may be separate, independent pieces of material and may be configured to emit light of same or different wavelength bands (e.g., first to third wavelength bands, respectively).

The encapsulation layer TFEL may be located on the common electrode CE and may cover the light emitting elements ED and thus may be on the first to third light emitting units EA1, EA2, and EA3. The encapsulation layer TFEL includes at least one inorganic layer to prevent oxygen or moisture from penetrating into the light emitting element layer EML. In addition, the encapsulation layer TFEL includes at least one organic layer to protect the light emitting element layer EML from foreign substances such as dust. For example, the encapsulation layer TFEL includes a first encapsulating inorganic layer TFE1, a first encapsulating organic layer TFE2, and a second encapsulating inorganic layer TFE3.

The first encapsulating inorganic layer TFE1 may be located on the common electrode CE, the first encapsulating organic layer TFE2 may be located on the first encapsulating inorganic layer TFE1, and the second encapsulating inorganic layer TFE3 may be located on the first encapsulating organic layer TFE2. Each of the first encapsulating inorganic layer TFE1 and the second encapsulating inorganic layer TFE3 may be a multilayer in which one or more inorganic layers selected from a silicon nitride layer, a silicon oxynitride layer, a silicon oxide layer, a titanium oxide layer, and an aluminum oxide layer are alternately stacked. The first encapsulating organic layer TFE2 may be an organic layer such as acryl resin, epoxy resin, phenol resin, polyamide resin, or polyimide resin.

The touch sensing layer TSU may be located on the encapsulation layer TFEL. The touch sensing layer TSU may include a first touch insulating layer TINS1, a second touch insulating layer TINS2, a sensor electrode SNE, absorption-reflection patterns AR1 and AR2, and a third touch insulating layer TINS3.

The first touch insulating layer TINS1 may be located on the encapsulation layer TFEL. The first touch insulating layer TINS1 may have insulating and optical functions. The first touch insulating layer TINS1 may include at least one inorganic layer. Optionally, the first touch insulating layer TINS1 may be omitted.

The second touch insulating layer TINS2 may cover the first touch insulating layer TINS1. Although not illustrated in the drawings, a sensor electrode SNE of another layer may be further located on the first touch insulating layer TINS1, and the second touch insulating layer TINS2 may cover this sensor electrode SNE. The second touch insulating layer TINS2 may be an inorganic layer including at least one of a silicon nitride layer, a silicon oxynitride layer, a silicon oxide layer, a titanium oxide layer, or an aluminum oxide layer.

The sensor electrode SNE and reflection patterns RP may be located on the second touch insulating layer TINS2. The sensor electrode SNE may be formed as a single layer of molybdenum (Mo), titanium (Ti), copper (Cu), aluminum (Al) or indium tin oxide (ITO) or may be formed as a stacked structure (Ti/Al/Ti) of aluminum and titanium, a stacked structure (ITO/Al/ITO) of aluminum and indium tin oxide, an APC alloy, or a stacked structure (ITO/APC/ITO) of an APC alloy and indium tin oxide. The reflection patterns RP may include the same material as the sensor electrode SNE or may include a different material from the sensor electrode SNE. When the reflection patterns RP include a different material from the sensor electrode SNE, the reflectivity of the reflection patterns RP may be higher than the reflectivity of the sensor electrode SNE.

The sensor electrode SNE may not overlap (e.g., may be exposed from) light emitting units EA1, EA2 and EA3 in the thickness direction of the substrate SUB (e.g., in plan view, in the third direction DR3, etc.). The reflection patterns RP may overlap a first light emitting unit EA1 and a second light emitting unit EA2 in the thickness direction of the substrate SUB.

The reflection patterns RP may include multiple reflection patterns, for example a first reflection pattern RP1 and a second reflection patten RP2, that may overlap separate light emitting units (e.g., the first light emitting unit EA1 and the second light emitting unit EA2, respectively). The reflection pattern RP of each of the absorption-reflection patterns AR1 and AR2 may reflect a portion of light emitted by the light emitting element ED of a light emitting unit, to reduce, minimize, or prevent absorption of such light by a color pattern CP of the absorption-reflection patterns AR1 and AR2 that are configured to reduce reflectance (e.g., reflectance of the display device 1) due to external light. Therefore, the output ratio of the light emitted by the light emitting element ED (also referred to as output ratio of the display device 1) may not be reduced by such color patterns CP, while such color patterns CP may reduce reflectance with regard to external light. For example, a portion of light emitted by the first light emitting unit EA1 toward a first color filter CF1 may be reflected toward the first pixel electrode AE1 by a reflection pattern RP (e.g., a first reflection pattern RP1) overlapping the first light emitting unit EA1 (e.g., overlapping in the thickness direction of the substrate SUB). The light reflected by the reflection pattern RP may be reflected again by the first pixel electrode AE1 toward the first color filter CF1 and may pass through the first color filter CF1 while bypassing a first color portion CP1 that is on the reflection pattern RP and thereby avoiding absorption of the reflected light by the first color patten CP1. A portion of light emitted by the second light emitting unit EA2 toward a second color filter CF2 may be reflected toward the second pixel electrode AE2 by a reflection pattern RP (e.g., a second reflection pattern RP2) overlapping the second light emitting unit EA2 (e.g., overlapping in the thickness direction of the substrate SUB). The light reflected by the reflection pattern RP may be reflected again by the second pixel electrode AE2 toward the second color filter CF2 and may pass through the second color filter CF2 while bypassing a second color portion CP2 that is on the reflection pattern RP and thereby avoiding absorption of the reflected light by the second color patten CP2. Therefore, when a first absorption-reflection pattern AR1 includes a reflection pattern RP (e.g., a first reflection pattern RP1), light emitted from the light emitting element ED of the first light emitting unit EA1 may be reflected by the reflection pattern RP and the first pixel electrode AE1 to the outside without being absorbed by a first color pattern CP1. Therefore, it is possible to prevent the output ratio of the light emitted by the light emitting element ED from being reduced by the first color pattern CP1 or reduce or minimize such reduction (e.g., reduce, minimize, or prevent the output ratio of the display device 1 from being reduced by the first color pattern CP1 or reduce or minimize such reduction), while the first color pattern CP1 may reduce reflectance due to external light (e.g., reduce reflectance of the display device 1 due to the external light, also referred to herein interchangeably as incident light that is incident on the display device from an external environment or ambient environment that is external to the display device 1). Additionally, when a second absorption-reflection pattern AR2 includes a reflection pattern RP (e.g., a second reflection pattern RP2), light emitted from the light emitting element ED of the second light emitting unit EA2 may be reflected by the reflection pattern RP and the second pixel electrode AE2 to the outside without being absorbed by a second color pattern CP2. Therefore, it is possible to reduce the output ratio of the light emitted by the light emitting element ED from being reduced by the second color pattern CP2 or reduce or minimize such reduction (e.g., reduce, minimize, or prevent the output ratio of the display device 1 from being reduced by the second color pattern CP2 or reduce or minimize such reduction), while the second color pattern CP2 may reduce reflectance due to external light (e.g., reduce reflectance of the display device 1 due to the external light).

Restated more generally, a reflection pattern RP overlapping a light emitting element ED may be configured to reduce, minimize, or prevent an output ratio of the light emitted by the light emitting element ED from being reduced by a color pattern CP that overlaps the light emitting element ED, based on enabling internal reflection within the display device 1 of such emitted light between the reflection pattern RP and the light emitting element ED (e.g., a pixel electrode AE thereof), which may enable such internally reflected light to be emitted through the third touch insulating layer TINS3 to bypass absorption by the color pattern CP. As a result, the first and second absorption-reflection patterns AR1 and AR2 may be configured to reduce reflectance (e.g., reflectance of the display device 1) due to external light without compromising the output ratio of the light emitted by the light emitting elements ED of the light emitting units (e.g., the output ratio of the display device 1). Thus, the display device 1 may exhibit improved light emitting performance and/or efficiency (also referred to herein interchangeably as image displaying performance and/or efficiency, respectively) based on exhibiting reduced reflectance due to external light (to thereby improve visibility of images displayed by the display device 1) without compromising output ratio of light emitted by the light emitting elements ED of the light emitting units of the display device 1 (thereby even further improving visibility of such displayed images), based on the display device 1 including one or more absorption-reflection patterns that include a reflection pattern RP exposed by a hole penetrating an insulating layer (e.g., third touch insulating layer TINS) and a color pattern CP at least partially on the hole and on the reflection pattern RP exposed by the hole.

The reflection patterns RP may be electrically isolated from the sensor electrode SNE. The reflection patterns RP may be spaced apart from the sensor electrode SNE and may be surrounded by the sensor electrode SNE.

Widths of the reflection patterns RP in one direction may be different from a width of the sensor electrode SNE in the direction. The widths of the reflection patterns RP in the direction may be set in consideration of resonating and outputting light emitted from the light emitting elements, but the width of the sensor electrode SNE in the direction may be set in consideration of widths of the light emitting units and a width of the first light blocking layer BM1.

As illustrated in FIG. 5, the sensor electrode SNE may have a mesh or net structure surrounding each of the light emitting units EA1, EA2 and EA3 in plan view, but the reflection patterns RP may have a circular or polygonal planar shape.

The third touch insulating layer TINS3 may cover the sensor electrode SNE, the reflection patterns RP, and the second touch insulating layer TINS2. The third touch insulating layer TINS3 may have insulating and optical functions. The third touch insulating layer TINS3 may include any one of the materials exemplified in the description of the second touch insulating layer TINS2. The third touch insulating layer TINS3 may include holes through which first and second color patterns CP1 and CP2 pass.

The color patterns CP may be located on the third touch insulating layer TINS3 of the touch sensing layer TSU. The color patterns CP may overlap (e.g., overlap in the thickness direction of the substrate SUB) the light emitting units EA1, EA2, EA3, but may not be located in and/or may not overlap some light emitting units. For example, the first color pattern CP1 may overlap the first light emitting unit EA1, and the second color pattern CP2 may overlap the second light emitting unit EA2, but no color pattern CP may be located in and/or overlap a third light emitting unit EA3. The color patterns CP1 and CP2 may include the same material as a third color filter CF3, but example embodiments are not limited thereto. Since a reflection color may vary depending on the material of the color patterns CP, various materials may be applied to the color patterns CP depending on the desired reflection color. For example, for a blue reflection color, the first and second color patterns CP1 and CP2 may be the same material as the third color filter CF3 as illustrated in FIG. 6.

The color patterns CP may be at least partially inserted into color pattern holes H1 and H2 formed in the third touch insulating layer TINS3 (e.g., defined by one or more inner side surfaces TINS3-s of the third touch insulating layer TINS3-s, such that the third touch insulating layer TINS3 may be understood to include the first and second color pattern holes H1 and H2) to contact the reflection patterns RP. The color pattern holes H1 and H2 may be holes that penetrate the third touch insulating layer TINS3 to expose the reflection patterns RP. For example, in example embodiments where the reflection patterns RP include a first reflection pattern RP1 overlapping the first light emitting unit EA1 (e.g., overlapping in the thickness direction of the substrate SUB) and a second reflection pattern RP2 overlapping the second light emitting unit EA2, the third touch insulating layer TINS3 may include (e.g., may include one or more surfaces that define) first and second color pattern holes H1 and H2 penetrating the third touch insulating layer TINS3 and exposing the first and second reflection patterns RP1 and RP2, respectively (e.g., the first reflection pattern RP1 at least partially exposed by the first color pattern hole H1 and the second reflection pattern RP exposed by the second color pattern hole H2). The first color pattern CP1 may be at least partially in the first color pattern hole H1 and on the first reflection pattern RP1 that is exposed from the third touch insulating layer TINS3 by the first color pattern hole H1, and the second color pattern CP2 may be at least partially in the second color pattern hole H2 and on the second reflection pattern RP2 that is exposed from the third touch insulating layer TINS3 by the second color pattern hole H2.

The first color pattern CP1 may cover the reflection pattern RP overlapping (e.g., in the thickness direction of the substrate SUB) the first light emitting unit EA1. The second color pattern CP2 may cover the reflection pattern RP overlapping (e.g., in the thickness direction of the substrate SUB) the second light emitting unit EA2.

The first light blocking layer BM1 and the color patterns CP1 and CP2 may be defined as protruding patterns that protrude from an upper surface TINS3-u of the third touch insulating layer TINS3. A thickness, in the thickness direction of the substrate SUB (e.g., the third direction DR3), of the color patterns CP (e.g., any one or more of the first color pattern CP1 and/or the second color pattern CP2) may be greater than a thickness, in the thickness direction of the substrate SUB, of the first light blocking layer BM1. A height P1 from the third touch insulating layer TINS3 to an upper surface BM1-u of the first light blocking layer BM1 may be defined as a height of a first protruding pattern, and a height P2 from the third touch insulating layer TINS3 to an upper surface CP-u of each of the color patterns CP1 and CP2 may be defined as a height of a second protruding pattern.

The smaller the difference between the height P1 of the first protruding pattern and the height P2 of the second protruding pattern, the more uniform (e.g., even, planar, etc.) the uneven shape defined by the third touch insulating layer TINS3 and the protruding patterns. The more uniform the uneven shape, the lower the diffuse reflectance of light incident from the outside. The diffuse reflectance refers to light that is not reflected at the same angle as an incident angle of the light incident on a surface of an object, but is reflected at a different angle from the incident angle. The more even (e.g., planar) the surface, the lower the diffuse reflectance, and the more uneven the surface, the higher the diffuse reflectance. Therefore, the surface becomes more even (e.g., planar) as the difference between the height from the third touch insulating layer TINS3 to the upper surface BM1-u of the first light blocking layer BM1 and the height from the third touch insulating layer TINS3 to the upper surface CP-u of each of the color patterns CP1 and CP2 decreases, which results in a reduction in the diffuse reflectance and thus improves the image displaying and/or light emitting functionality of the display device 1 based on improving visibility of an image and/or light displayed by the display device 1 based on reducing, minimizing, or preventing reflectance due to external light that might otherwise reduce the visibility of the displayed image.

As illustrated in FIG. 7, an angle θ formed by side surfaces CP-s of the second color pattern CP2 penetrating the third touch insulating layer TINS3 and a lower surface TINS3-b of the third touch insulating layer TINS3 may be in a range of 10 degrees to 90 degrees (inclusively). A reflection color of a color pattern CP may be adjusted according to the area (e.g., surface area, for example a surface area in the plan view, a surface area in a plane parallel to the lower surface TINS3-b, or the like) of the color pattern CP. For example, when the area of the second color pattern CP2 is increased, the reflection color reflected by the color pattern CP may be expressed closer to blue. When the area of the second color pattern CP2 is reduced, the reflection color reflected by the color pattern CP may be expressed closer to a color other than blue, for example, closer to red or green.

The area of the second color pattern CP2 may be adjusted using the angle θ formed by the side surfaces CP-s of the second color pattern CP2 and the lower surface TINS3-b of the third touch insulating layer TINS3. The closer the angle θ formed by the side surfaces CP-s of the second color pattern CP2 and the lower surface TINS3-b of the third touch insulating layer TINS3 is to 10 degrees, the wider the area of the second color pattern CP2, and the closer the angle θ formed by the side surfaces CP-s of the second color pattern CP2 and the lower surface TINS3-b of the third touch insulating layer TINS3 is to 90 degrees, the narrower the area of the second color pattern CP2.

In FIG. 7, the second color pattern CP2 covers both an upper surface RP-u and side surfaces RP-s of a reflection pattern RP. However, example embodiments are not limited thereto. For example, a second color pattern hole H2 may be formed to expose only the upper surface RP-u of the reflection pattern RP without exposing the side surfaces RP-s of the reflection pattern RP. In this case, the color pattern CP2 may be located on the upper surface RP-u of the reflection pattern RP. That is, the second color pattern CP2 may contact the upper surface RP-u of the reflection pattern RP and may not contact the side surfaces RP-s of the reflection pattern RP.

The first light blocking layer BM1 may be located on the third touch insulating layer TINS3 of the touch sensing layer TSU. The first light blocking layer BM1 may cover (e.g., overlap in the thickness direction of the substrate SUB) the sensor electrode SNE and may include (e.g., may have one or more inner surfaces BM1-s defining) a plurality of openings OPT1, OPT2 and OPT3 overlapping (e.g., overlapping in the thickness direction of the substrate SUB) the light emitting units EA1, EA2 and EA3. For example, a first opening OPT1 may overlap the first light emitting unit EA1, a second opening OPT2 may overlap the second light emitting unit EA2, and a third opening OPT3 may overlap the third light emitting unit EA3. The areas or sizes of the openings OPT1, OPT2 and OPT3 (e.g., areas or sizes in a plane extending parallel to the substrate SUB and/or extending perpendicular to the thickness direction of the substrate SUB) may be larger than the areas or sizes of the first light emitting unit EA1, the second light emitting unit EA2 and the third light emitting unit EA3, respectively. The areas or sizes of the pixel electrodes AE may be larger than the areas or sizes of the openings of the pixel defining layer PDL. Light emitted from the light emitting elements ED can be viewed by a user not only from the front but also from the side of the display device 1.

The first light blocking layer BM1 may have a width (e.g., in one or more directions extending parallel to the substrate SUB and/or extending perpendicular to the thickness direction of the substrate SUB) sufficient to completely cover the sensor electrode SNE (e.g., overlap the sensor electrode SNE in the thickness direction of the substrate SUB). The first light blocking layer BM1 may prevent light incident from the outside from being reflected by the sensor electrode SNE, or reduce or minimize such reflection.

The first light blocking layer BM1 may include a light absorbing material. For example, the first light blocking layer BM1 may include an inorganic black pigment or an organic black pigment. The inorganic black pigment may be carbon black, and the organic black pigment may include at least one of lactam black, perylene black or aniline black, but embodiments are not limited to this example.

The color filters CF1, CF2 and CF3 may be located on the first light blocking layer BM1, the color patterns CP, and the third touch insulating layer TINS3. The color filters CF1, CF2 and CF3 may be placed to correspond to (e.g., overlap in the thickness direction of the substrate SUB) the light emitting units EA1, EA2 and EA3, respectively. For example, the first color filter CF1 may be placed to correspond to the first light emitting unit EA1, the second color filter CF2 may be placed to correspond to the second light emitting unit EA2, and the third color filter CF3 may be placed to correspond to the third light emitting unit EA3. The color filters CF1, CF2 and CF3 may be placed to correspond to the openings OPT1, OPT2 and OPT3 of the first light blocking layer BM1, respectively. For example, the first color filter CF1 may be placed to correspond to the first opening OPT1, the second color filter CF2 may be placed to correspond to the second opening OPT2, and the third color filter CF3 may be placed to correspond to the third opening OPT3.

Each of the color filters CF1, CF2 and CF3 may cover a portion of the adjacent first light blocking layer BM1. The color filters CF1, CF2 and CF3 may overlap each other in the third direction DR3 (which may be the thickness direction of the substrate SUB) on the first light blocking layer BM1.

Each of the color filters CF1, CF2 and CF3 may completely cover a color pattern CP. For example, the first color filter CF1 may completely cover the first color pattern CP1, and the second color filter CF2 may completely cover the second color pattern CP2.

The passivation layers PSV1 and PSV2 may be located on the first light blocking layer BM1 and the color filter layer CFL. The passivation layers PSV1 and PSV2 may be located over the entire display area DA to flatten an upper surface of the display panel 100. The passivation layers PSV1 and PSV2 may include a first passivation layer PSV1 located on the color filter layer CFL and the first light blocking layer BM1 and a second passivation layer PSV2 located on the first passivation layer PSV1. The passivation layers PSV1 and PSV2 may include a plurality of layers to flatten a step caused by the color filter layer CFL and the first light blocking layer BM1. In some example embodiments, the second passivation layer PSV2 may be omitted.

The passivation layers PSV1 and PSV2 may include a colorless light-transmitting layer that does not have a color in a visible light band. For example, the passivation layers PSV1 and PSV2 may include a colorless light-transmitting organic material such as acrylic resin.

The overcoat layer OC may be located on the passivation layers PSV1 and PSV2. The overcoat layer OC may be located over the entire display area DA to flatten the upper surface of the display panel 100. The overcoat layer OC may be a colorless light-transmitting layer that does not have a color in the visible light band. For example, the overcoat layer OC may include a colorless light-transmitting organic material such as acrylic resin.

Since the display device 1 according to some example embodiments includes the color filter layer CFL, it can reduce reflected light due to external light by absorbing a portion of the light incident from the outside of the display device 1. Therefore, the color filter layer CFL can reduce, minimize, or prevent color distortion due to the reflection of external light. In addition, since a separate polarizing plate for reducing the reflection of external light is not required, the light output efficiency of the display device 1 can be improved.

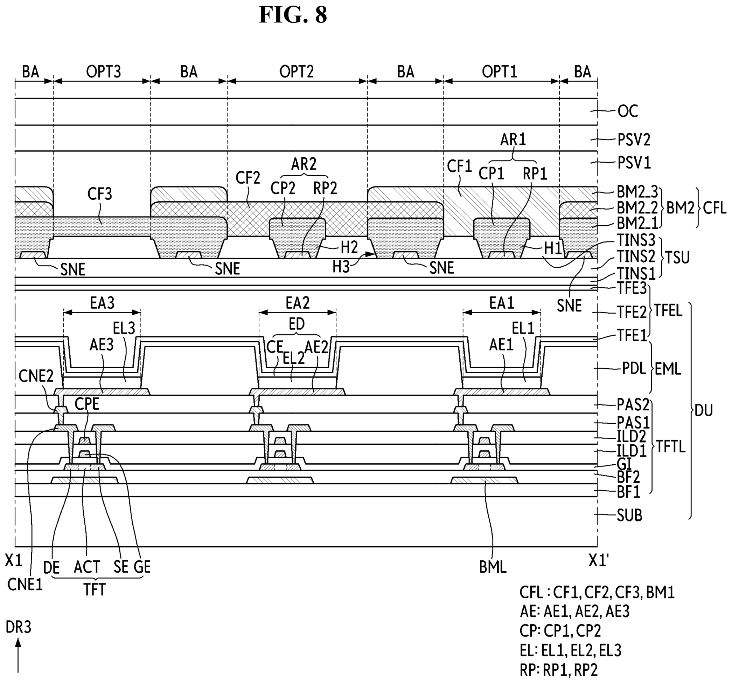

FIGS. 8, 9, 10, 11, 12, 13, and 14 are cross-sectional views of examples of the display panel 100 taken along line X1-X1' of FIG. 5 according to some example embodiments.

In the embodiments of FIGS. 8 through 14, a description of elements and features identical to those of the embodiment of FIGS. 6 and 7 will be omitted, and differences from the embodiments of FIGS. 8 through 14 will be mainly described.

FIG. 8 illustrates a display panel 100 according to some example embodiments in which a second light blocking layer BM2 is applied instead of the first light blocking layer BM1 of FIG. 6.

Referring to FIG. 8, the second light blocking layer BM2 may include a first sub-light blocking layer BM2_1, a second sub-light blocking layer BM2_2, and a third sub-light blocking layer BM2_3 overlapping each other in a thickness direction of a substrate SUB. A color filter layer CFL may include a light blocking area BA including the second light blocking layer BM2 and first through third openings OPT1 through OPT3 excluding the light blocking area BA.

A third touch insulating layer TINS3 may further include (e.g., may include one or more inner surfaces TINS3-s that define) a plurality of third color pattern holes H3 through which the first sub-light blocking layer BM2_1 passes. The third color pattern holes H3 may be formed to expose a sensor electrode SNE.

The first sub-light blocking layer BM2_1 may be inserted into the third color pattern holes H3 such that the first sub-light blocking layer BM2_1 is at least partially in the third color pattern holes H3 to directly contact the sensor electrode SNE and cover the sensor electrode SNE. The first sub-light blocking layer BM2_1 may be formed at the same height (e.g., distance from the substrate SUB in the thickness direction of the substrate SUB) as color patterns CP.

Since the first sub-light blocking layer BM2_1 is located in the same layer as the color patterns CP, the first sub-light blocking layer BM2_1 and the color patterns CP may be the same material. In some example embodiments, the first sub-light blocking layer BM2_1 and the color patterns CP are the same material as a third color filter CF3. However, the first sub-light blocking layer BM2_1 may vary depending on the material of the color patterns CP. For example, when the color patterns CP are the same material as a first color filter CF1 or a second color filter CF2, the first sub-light blocking layer BM2_1 may be the same material as the first color filter CF1 or the second color filter CF2.

The first sub-light blocking layer BM2_1 may include the same material as the third color filter CF3. The first sub-light blocking layer BM2_1 may extend from the third color filter CF3. The third color filter CF3 may be located in the third opening OPT3, and the first sub-light blocking layer BM2_1 may be located in the light blocking area BA. The first sub-light blocking layer BM2_1 may not overlap (e.g., may be exposed from, in the thickness direction of the substrate SUB) the first opening OPT1 and the second opening OPT2.

The second sub-light blocking layer BM2_2 may include the same material as the second color filter CF2. The second sub-light blocking layer BM2_2 may extend from the second color filter CF2. The second color filter CF2 may be located in the second opening OPT2, and the second sub-light blocking layer BM2_2 may be located in the light blocking area BA. The second sub-light blocking layer BM2_2 may not overlap (e.g., may be exposed from, in the thickness direction of the substrate SUB) the first opening OPT1 and the third opening OPT3.

The third sub-light blocking layer BM2_3 may include the same material as the first color filter CF1. The third sub-light blocking layer BM2_3 may extend from the first color filter CF1. The first color filter CF1 may be located in the first opening OPT1, and the third sub-light blocking layer BM2_3 may be located in the light blocking area BA. The third sub-light blocking layer BM2_3 may not overlap (e.g., may be exposed from, in the thickness direction of the substrate SUB) the second opening OPT2 and the third opening OPT3.

In some example embodiments, the second sub-light blocking layer BM2_2 includes the same material as the second color filter CF2, and the third sub-light blocking layer BM2_3 includes the same material as the first color filter CF1. However, embodiments are not limited thereto, and the materials of the second and third sub-light blocking layers BM2_2 and BM2_3 may vary depending on the process order of the color filter layer CFL. For example, when the first color filter CF1 is formed after the third color filter CF3 is formed, the second sub-light blocking layer BM2_2 may include the same material as the first color filter CF1, and the third sub-light blocking layer BM2_3 may include the same material as the second color filter CF2. When the second color filter CF2 is formed after the third color filter CF3 is formed, the second sub-light blocking layer BM2_2 may include the same material as the second color filter CF2, and the third sub-light blocking layer BM2_3 may include the same material as the first color filter CF1.

Since the second light blocking layer BM2 can absorb all or substantially all of first light, second light and third light incident from the outside by using the first through third sub-light blocking layers BM2_1 through BM2_3, it can prevent the light incident from the outside from being reflected by the sensor electrode SNE, or reduce or minimize such reflection.

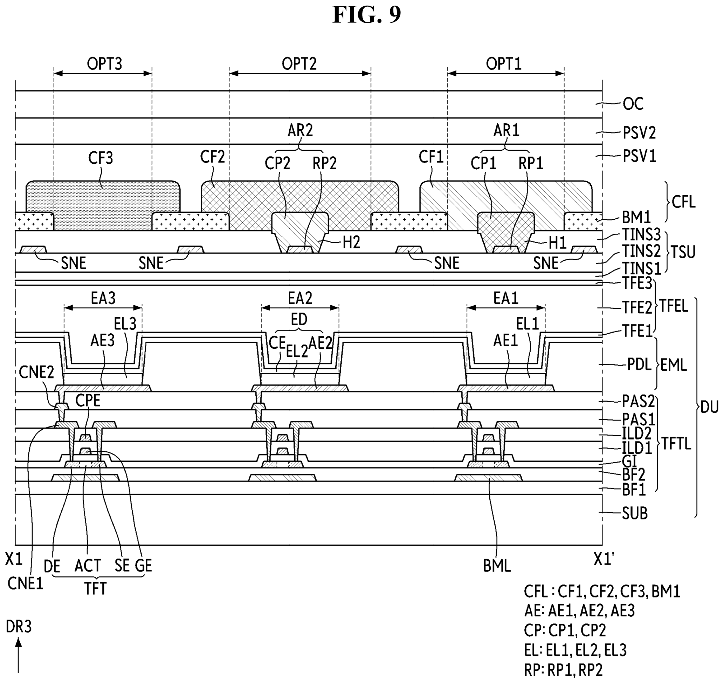

FIG. 9 is different from FIGS. 6 and 7 in that materials of a first color pattern CP1 and a second color pattern CP2 are different.

Referring to FIG. 9, the first color pattern CP1 may be the same material as a second color filter CF2, and the second color pattern CP2 may be the same material as a first color filter CF1.

Since each of the first and second color patterns CP1 and CP2 uses the same material as the first color filter CF1 or the second color filter CF2, a reflection color due to external light can be adjusted. When the first and second color patterns CP1 and CP2 are the same material as a third color filter CF3 as in FIG. 6, a blue reflection color may be expressed. When each of the first and second color patterns CP1 and CP2 is the material of the first or second color filter CF1 or CF2 as in FIG. 9, the blue reflection color may be reduced, and a red or green reflection color may be expressed more.

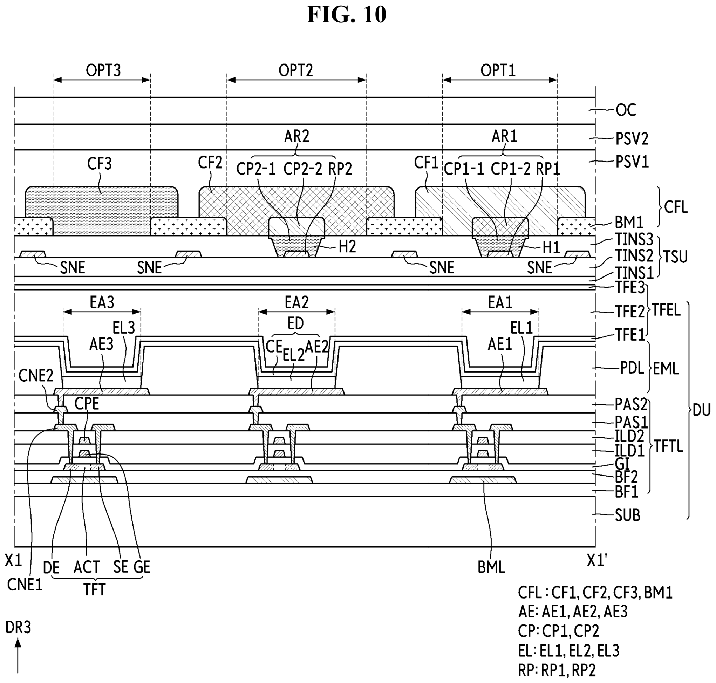

FIG. 10 is different from FIGS. 6 and 7 in that each color pattern CP has a multilayer structure.

Referring to FIG. 10, a first absorption-reflection pattern AR1 may include a (1-1)^{th} color pattern CP1-1, a (1-2)^{th} color pattern CP1-2, and a reflection pattern RP (e.g., a first reflection pattern RP1). The (1-1)^{th} color pattern CP1-1 may be inserted into a first color pattern hole H1 to contact the reflection pattern RP. The (1-2)^{th} color pattern CP1-2 may be located on the (1-1)^{th} color pattern CP1-1. Depending on a thickness of the (1-1)^{th} color pattern CP1-1, a portion of the (1-2)^{th} color pattern CP1-2 may be located in the first color pattern hole H1. For example, if the thickness of the (1-1)^{th} color pattern CP1-1 is smaller than a depth of the first color pattern hole H1, a portion of the (1-2)^{th} color pattern CP1-2 may be placed in the first color pattern hole H1. Conversely, if the thickness of the (1-1)^{th} color pattern CP1-1 is greater than the depth of the first color pattern hole H1, the (1-2)^{th} color pattern CP1-2 may not be placed in the first color pattern hole H1.

In some example embodiments, the (1-1)^{th} color pattern CP1-1 is the same material as a third color filter CF3, and the (1-2)^{th} color pattern CP1-2 is the same material as a second color filter CF2. However, embodiments are not limited thereto. For example, the (1-1)^{th} color pattern CP1-1 may also be the same material as the second color filter CF2, and the (1-2)^{th} color pattern CP1-2 may also be the same material as the third color filter CF3. For example, the (1-1)-th color pattern CP1-1 may be configured to selectively transmit any one of the light of the second wavelength band (which the second color filter CF2 may be configured to selectively transmit) or the light of the third wavelength band (which the second color filter CF2 may be configured to selectively transmit), and the (1-2)-th color pattern CP1-2 may be configured to selectively transmit another one of the light of the second wavelength band or the light of the third wavelength band.

The (1-1)^{th} color pattern CP1-1, the (1-2)^{th} color pattern CP1-2, and a first color filter CF1 may be located on the reflection pattern RP to overlap each other in a thickness direction (e.g., the thickness direction of the substrate SUB). Since the (1-1)^{th} color pattern CP1-1, the (1-2)^{th} color pattern CP1-2, and the first color filter CF1 can absorb first through third light, a reflection color due to external light may be close to black.

A second absorption-reflection pattern AR2 may include a (2-1)^{th} color pattern CP2-1, a (2-2)^{th} color pattern CP2-2, and a reflection pattern RP (e.g., a second reflection pattern RP2). The (2-1)^{th} color pattern CP2-1 may be inserted into a second color pattern hole H2 to contact the reflection pattern RP. The (2-2)^{th} color pattern CP2-2 may be located on the (2-1)^{th} color pattern CP2-1. Depending on a thickness of the (2-1)^{th} color pattern CP2-1, a portion of the (2-2)^{th} color pattern CP2-2 may be placed in the second color pattern hole H2. For example, if the thickness of the (2-1)^{th} color pattern CP2-1 is smaller than a depth of the second color pattern hole H2, a portion of the (2-2)^{th} color pattern CP2-2 may be placed in the second color pattern hole H2. Conversely, if the thickness of the (2-1)^{th} color pattern CP2-1 is greater than the depth of the second color pattern hole H2, the (2-2)^{th} color pattern CP2-2 may not be placed in the second color pattern hole H2.

In some example embodiments, the (2-1)^{th} color pattern CP2-1 is the same material as the third color filter CF3, and the (2-2)^{th} color pattern CP2-2 is the same material as the first color filter CF1. However, embodiments are not limited thereto. For example, the (2-1)^{th} color pattern CP2-1 may also be the same material as the first color filter CF1, and the (2-2)^{th} color pattern CP2-2 may also be the same material as the third color filter CF3. For example, the (2-1)-th color pattern CP2-1 may be configured to selectively transmit any one of the light of the first wavelength band (which the first color filter CF1 is configured to selectively transmit) or the light of the third wavelength band (which the third color filter CF3 is configured to selectively transmit), and the (2-2)-th color pattern CP2-2 may be configured to selectively transmit another one of the light of the first wavelength band or the light of the third wavelength band.

The (2-1)^{th} color pattern CP2-1, the (2-2)^{th} color pattern CP2-2, and the second color filter CF2 may be located on the reflection pattern RP to overlap each other in the thickness direction. Since the (2-1)^{th} color pattern CP2-1, the (2-2)^{th} color pattern CP2-2, and the second color filter CF2 can absorb the first through third light, a reflection color due to external light may be close to black.

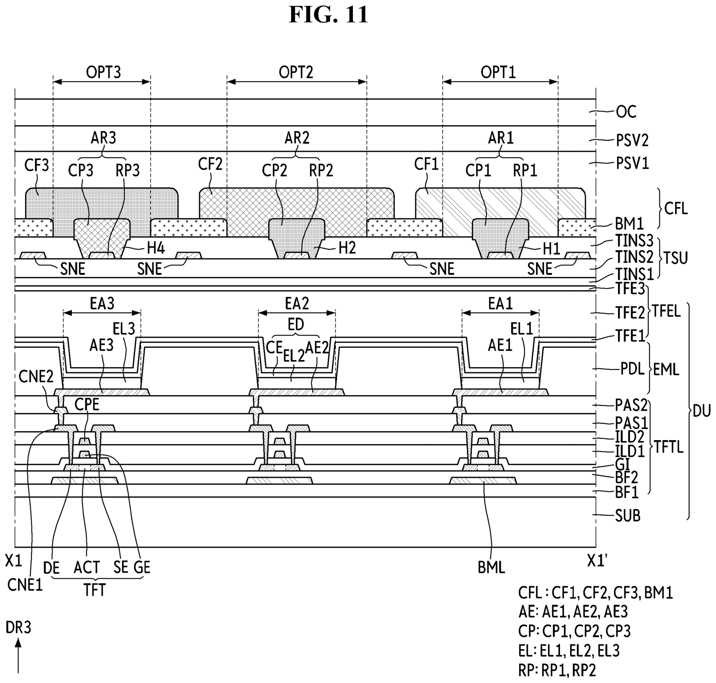

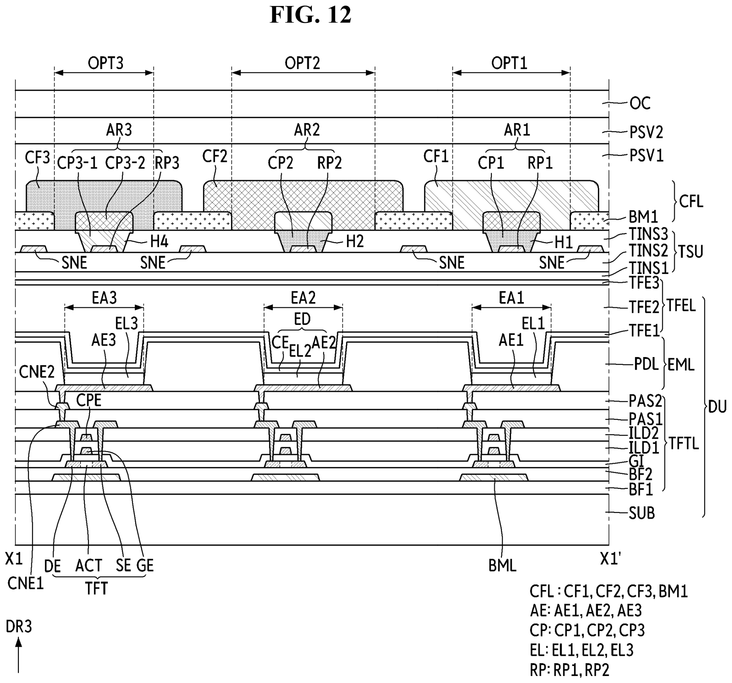

FIGS. 11 and 12 are different from FIGS. 6 and 10 in that a third absorption-reflection pattern AR3 is applied. The addition of the third absorption-reflection pattern AR3 can further reduce reflectance due to external light.

Referring to FIGS. 11 and 12, the third absorption-reflection pattern AR3 may include a reflection pattern RP (e.g., a third reflection pattern RP3) and a third color pattern CP3. The third absorption-reflection pattern AR3 may overlap a third light emitting unit EA3 in a thickness direction (e.g., the thickness direction of the substrate SUB). The reflection pattern RP of the third absorption-reflection pattern AR3 may be located on a second touch insulating layer TINS2.

A third touch insulating layer TINS3 may include (e.g., may define) a fourth color pattern hole H4 that penetrates the third touch insulating layer TINS3 and through which the third color pattern CP3 passes. The fourth color pattern hole H4 may be a hole that exposes the reflection pattern RP (e.g., the third reflection pattern RP3). The third color pattern CP3 may be inserted at least partially into the fourth color pattern hole H4 to contact the reflection pattern RP. Accordingly, as shown in FIGS. 11 and 12, the third touch insulating layer TINS3 may include a fourth color pattern hole H4 penetrating the third touch insulating layer TINS3 and exposing the third reflection pattern RP3, and the third color pattern CP3 may be at least partially in the fourth color pattern hole H4. The third color pattern CP3 may be covered by a third color filter CF3 located in a third hole OPT3.

As illustrated in FIG. 11, the third color pattern CP3 may be the same material as a second color filter CF2. However, embodiments are not limited thereto. The material of the third color pattern CP3 may vary depending on the desired reflection color. For example, if a red reflection color is desired, the third color pattern CP3 may be the same material as a first color filter CF1. In some example embodiments, if a green reflection color is desired, the third color pattern CP3 may be the same material as the second color filter CF2. In some example embodiments, if a black reflection color is desired, the third color pattern CP3 may be the same material as a first light blocking layer BM1.

As illustrated in FIG. 12, the third absorption-reflection pattern AR3 may include a (3-1)^{th} color pattern CP3-1, a (3-2)^{th} color pattern CP3-2, and a reflection pattern RP.

The (3-1)^{th} color pattern CP3-1 may be inserted into a fourth color pattern hole H4 to contact the reflection pattern RP. The (3-2)^{th} color pattern CP3-2 may be located on the (3-1)^{th} color pattern CP3-1. Depending on a thickness of the (3-1)^{th} color pattern CP3-1, a portion of the (3-2)^{th} color pattern CP3-2 may be placed in the fourth color pattern hole H4. For example, if the thickness of the (3-1)^{th} color pattern CP3-1 is smaller than a depth of the fourth color pattern hole H4, a portion of the (3-2)^{th} color pattern CP3-2 may be placed in the fourth color pattern hole H4. Conversely, if the thickness of the (3-1)^{th} color pattern CP3-1 is greater than the depth of the fourth color pattern hole H4, the (3-2)^{th} color pattern CP3-2 may not be placed in the fourth color pattern hole H4.

In some example embodiments, the (3-1)^{th} color pattern CP3-1 is the same material as a first color filter CF1, and the (3-2)^{th} color pattern CP3-2 is the same material as a second color pattern CF2. However, embodiments are not limited thereto. For example, the (3-1)^{th} color pattern CP3-1 may also be the same material as the second color filter CF2, and the (3-2)^{th} color pattern CP3-2 may also be the same material as the first color filter CF1.

The (3-1)^{th} color pattern CP3-1, the (3-2)^{th} color pattern CP3-2, and a third color filter CF3 may be located on the reflection pattern RP to overlap each other in the thickness direction. Since the (3-1)^{th} color pattern CP3-1, the (3-2)^{th} color pattern CP3-2, and the third color filter CF3 can absorb first through third light, a reflection color due to external light may be close to black. For example, the (3-1)-th color pattern CP3-1 may be configured to selectively transmit any one of the light of the first wavelength band (which the first color filter CF1 is configured to selectively transmit) or the light of the second wavelength band (which the second color filter CF2 is configured to selectively transmit), and the (3-2)-th color pattern CP3-2 may be configured to selectively transmit another one of the light of the first wavelength band or the light of the second wavelength band.

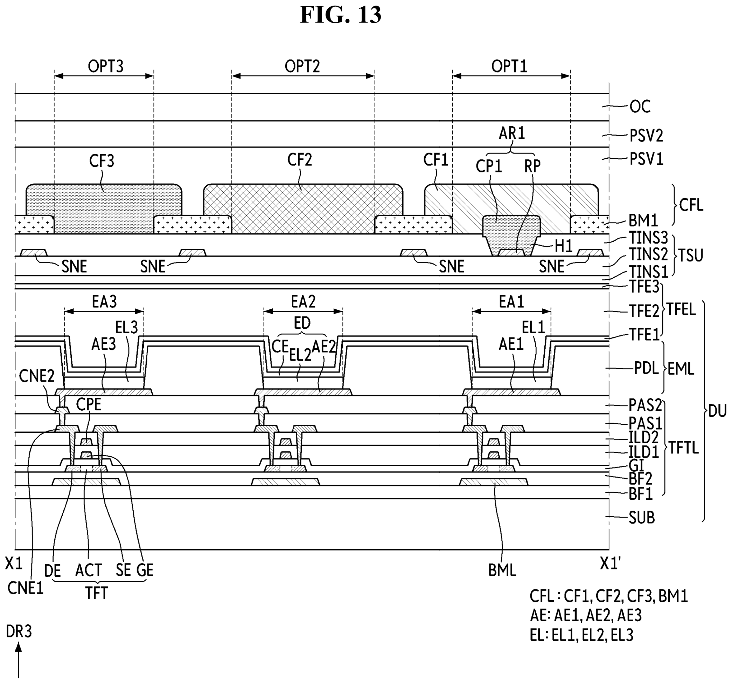

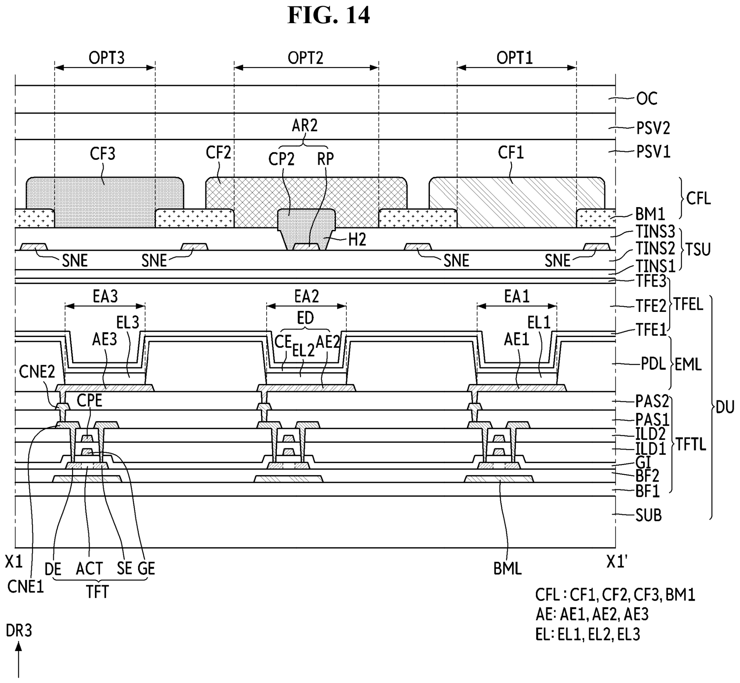

FIGS. 13 and 14 are different from FIGS. 6 and 7 in that a first absorption-reflection pattern AR1 or a second absorption-reflection pattern AR2 is removed (e.g., omitted from the display device 1).

FIG. 13 is some example embodiments in which the second absorption-reflection pattern AR2 is removed, and only the first absorption-reflection pattern AR1 is applied. FIG. 14 is some example embodiments in which the first absorption-reflection pattern AR1 is removed, and only the second absorption-reflection pattern AR2 is applied.

As illustrated in FIGS. 13 and 14, since only one of the first absorption-reflection pattern AR1 or the second absorption-reflection pattern AR2 is applied, a reflection color due to external light can be adjusted. The removal of one absorption-reflection pattern can reduce a blue reflection color.

A display device according to some example embodiments can be applied to (e.g., included in) various electronic devices. An electronic device according to some example embodiments includes the display device 1 described above and may further include modules or devices having additional functions, in addition to the display device.

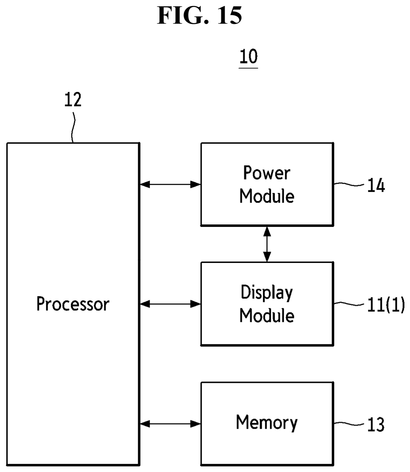

FIG. 15 is a block diagram of an electronic device 10 according to some example embodiments.

Referring to FIG. 15, the electronic device 10 according to some example embodiments may include a display module 11, a processor 12, a memory 13, and a power module 14.

The processor 12 may include at least one of a central processing unit (CPU), an application processor (AP), a graphic processing unit (GPU), a communication processor (CP), an image signal processor (ISP), or a controller.

The memory 13 may store data information necessary for the operation of the processor 12 or the display module 11. When the processor 12 executes an application stored in the memory 13, an image data signal and/or an input control signal may be transmitted to the display module 11, and the display module 11 may process the received signal and output image information through a display screen.

The power module 14 may include a power supply module, such as a power adapter or a battery device, and a power conversion module. The power conversion module may generate power necessary for the operation of the electronic device 10 by converting power supplied by the power supply module.

At least one of the elements of the electronic device 10 described above may be included in a display device 1 according to any of the example embodiments, including any of the example embodiments illustrated in any one or more of FIGS. 1 to 14. In addition, some of individual modules functionally included in one module may be included in the display device 1, and other modules may be provided separately from the display device 1. For example, the display device 1 may include the display module 11, and the processor 12, the memory 13 and the power module 14 may be provided not in the display device 1 but in the form of other devices within the electronic device 10.

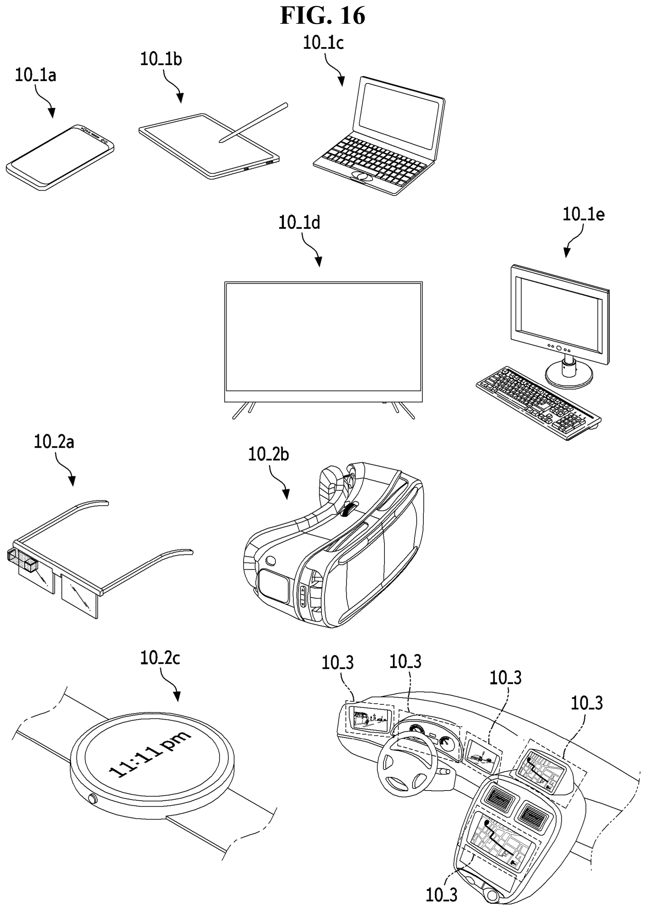

FIG. 16 is a schematic diagram of electronic devices according to some example embodiments.

Referring to FIG. 16, various electronic devices to which display devices 1 according to some example embodiments are applied (e.g., electronic devices including one or more display devices 1 according to any of the example embodiments, including any of the example embodiments illustrated in any one or more of FIGS. 1 to 14) may include image display electronic devices such as a smartphone 10_1a, a tablet PC 10_1b, a laptop 10_1c, a television 10_1d, and a desk monitor 10_1e. In addition, the various electronic devices to which the display devices 1 according to some example embodiments are applied may include wearable electronic devices including a display module, such as smart glasses 10_2a, a head-mounted display 10_2b and a smart watch 10_2c, and vehicle electronic devices 10_3 including a display module, such as a center information display (CID) and a room mirror display placed on an instrument cluster, center fascia and dashboard of a vehicle.

As described herein, any devices, systems, modules, portions, units, controllers, circuits, and/or portions thereof according to any of the example embodiments, and/or any portions thereof (including, without limitation, display device 1, display panel 100, display driver 200, display circuit board 300, touch driver 400, electronic device 10, processor 12, memory 13, display module 11, power module 14, smartphone 10_1a, tablet PC 10_1b, laptop 10_1c, TV 10_1d, desk monitor 10_1 e, smart glasses 10_2a, any portion thereof, or the like) may include, may be included in, and/or may be implemented by one or more instances of processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a graphics processing unit (GPU), an application processor (AP), a digital signal processor (DSP), a microcomputer, a field programmable gate array (FPGA), and programmable logic unit, a microprocessor, application-specific integrated circuit (ASIC), a neural network processing unit (NPU), an Electronic Control Unit (ECU), an Image Signal Processor (ISP), and the like. In some example embodiments, the processing circuitry may include a non-transitory computer readable storage device (e.g., a memory), for example a solid state drive (SSD), storing a program of instructions, and a processor (e.g., CPU) configured to execute the program of instructions to implement the functionality and/or methods performed by some or all of any devices, systems, modules, portions, units, controllers, circuits, and/or portions thereof according to any of the example embodiments.

As discussed, embodiments may provide a display device, comprising: a substrate; a first light emitting unit on the substrate, the first light emitting unit being configured to emit light of a first wavelength band; a second light emitting unit on the substrate, the second light emitting unit being configured to emit light of a second wavelength band; a third light emitting unit on the substrate, the third light emitting unit being configured to emit light of a third wavelength band; an encapsulation layer on the first light emitting unit, the second light emitting unit, and the third light emitting unit; a first color filter on the encapsulation layer, the first color filter overlapping the first light emitting unit in a thickness direction of the substrate, the first color filter being configured to selectively transmit the light of the first wavelength band; a second color filter on the encapsulation layer, the second color filter overlapping the second light emitting unit in the thickness direction of the substrate, the second color filter being configured to selectively transmit the light of the second wavelength band; a third color filter on the encapsulation layer, the third color filter overlapping the third light emitting unit in the thickness direction of the substrate, the third color filter being configured to selectively transmit the light of the third wavelength band; a first reflection pattern on the encapsulation layer, the first reflection pattern overlapping the first light emitting unit in the thickness direction of the substrate; a first insulating layer on the encapsulation layer, the first insulating layer including a first hole penetrating the first insulating layer and exposing the first reflection pattern; and a first color pattern at least partially in the first hole and on the first reflection pattern exposed by the first hole.

Hence, the first insulating layer comprises the first hole that exposes the first reflection pattern. The first insulating layer may be on a second insulating layer that is on the encapsulation layer. The first reflection pattern may be directly on the second insulating layer.

The first color pattern may cover the first reflection pattern and a portion of the first insulating layer.

As a result of the above, the first color filter may be considered to be associated with the first reflection pattern and the first color pattern.

The first color pattern may include the same material as the third color filter.

A portion of the first, second and third color filters may be on the first insulating layer.

A second reflection pattern may be provided on the encapsulation layer, the second reflection pattern overlapping the second light emitting unit in the thickness direction of the substrate, wherein the first insulating layer includes a second hole penetrating the first insulating layer and exposing the second reflection pattern. Furthermore, a second color pattern may at least partially be disposed in the second hole and on the second reflection pattern exposed by the second hole.

Hence, the second color filter may be associated with the second reflection pattern and the second color pattern.

The first color pattern may include the same material as the third color filter.

In some embodiments, the third color filters is not associated with a reflection pattern or color patter. The first insulating layer in the region of the third color filters may have a planar upper surface.

A third reflection pattern may be provided on the encapsulation layer, the third reflection pattern overlapping the third light emitting unit in the thickness direction of the substrate, wherein the first insulating layer includes a third hole penetrating the first insulating layer and exposing the third reflection pattern. Furthermore, a third color pattern may at least partially be disposed in the third hole and on the third reflection pattern exposed by the third hole.

Hence, the third color filter may be associated with the third reflection pattern and the third color pattern.

The third color pattern may be the same material as the second color filter.

A light blocking layer may be provided on the first insulating layer, with portions of the light blocking layer between the first, second and third color filters. The first, second and third color filters may respectively cover portions of the light blocking layer and portions of the first insulating layer - with the first color filter also covering the first color pattern (with the second color filter also covering the second color pattern, and the third color filter also covering the third color pattern if these are present).

Embodiments may provide an electronic device, comprising: a display module configured to display an image; and a processor configured to transmit an image data signal to the display module, wherein the display module includes a substrate, a first light emitting unit on the substrate, the first light emitting unit being configured to emit light of a first wavelength band, a second light emitting unit on the substrate, the second light emitting unit being configured to emit light of a second wavelength band, a third light emitting unit on the substrate, the third light emitting unit being configured to emit light of a third wavelength band, an encapsulation layer on the first light emitting unit, the second light emitting unit, and the third light emitting unit, a first color filter on the encapsulation layer, the first color filter overlapping the first light emitting unit in a thickness direction of the substrate, the first color filter configured to selectively transmit the light of the first wavelength band, a second color filter on the encapsulation layer, the second color filter overlapping the second light emitting unit in the thickness direction of the substrate, the second color filter being configured to selectively transmit the light of the second wavelength band, a third color filter on the encapsulation layer, the third color filter overlapping the third light emitting unit in the thickness direction of the substrate, the third color filter being configured to selectively transmit the light of the third wavelength band, a first reflection pattern on the encapsulation layer, the first reflection pattern overlapping the first light emitting unit in the thickness direction of the substrate, a first insulating layer on the encapsulation layer, the first insulating layer including a first hole penetrating the first insulating layer and exposing the first reflection pattern; and a first color pattern at least partially in the first hole and on the first reflection pattern exposed by the first hole.

The inventive concepts should not be construed as being limited to the example embodiments set forth herein. Rather, these example embodiments are provided so that the description of the inventive concepts will be thorough and complete and will fully convey the inventive concepts to those skilled in the art.

While the inventive concepts have been particularly shown and described with reference to some example embodiments thereof, it will be understood by those of ordinary skill in the art that various changes in form and details may be made therein without departing from the scope of the inventive concepts as defined by the following claims.

## Claims

1. A display device, comprising:
a substrate;
a first light emitting unit on the substrate, the first light emitting unit being configured to emit light of a first wavelength band;
a second light emitting unit on the substrate, the second light emitting unit being configured to emit light of a second wavelength band;
a third light emitting unit on the substrate, the third light emitting unit being configured to emit light of a third wavelength band;
an encapsulation layer on the first light emitting unit, the second light emitting unit, and the third light emitting unit;
a first color filter on the encapsulation layer, the first color filter overlapping the first light emitting unit in a thickness direction of the substrate, the first color filter being configured to selectively transmit the light of the first wavelength band;
a second color filter on the encapsulation layer, the second color filter overlapping the second light emitting unit in the thickness direction of the substrate, the second color filter being configured to selectively transmit the light of the second wavelength band;
a third color filter on the encapsulation layer, the third color filter overlapping the third light emitting unit in the thickness direction of the substrate, the third color filter being configured to selectively transmit the light of the third wavelength band;
a first reflection pattern on the encapsulation layer, the first reflection pattern overlapping the first light emitting unit in the thickness direction of the substrate;
a first insulating layer on the encapsulation layer, the first insulating layer including a first hole penetrating the first insulating layer and exposing the first reflection pattern; and
a first color pattern at least partially in the first hole and on the first reflection pattern exposed by the first hole.

2. The display device of claim 1, wherein the first color pattern contacts the first reflection pattern.

3. The display device of claim 1 or 2, wherein the first color pattern contacts the first color filter.

4. The display device of any one of claims 1 to 3, wherein an angle defined by a side surface of the first color pattern and a lower surface of the first insulating layer is in a range of 10 degrees to 90 degrees.

5. The display device of any one of claims 1 to 4, further comprising:
a second insulating layer on the encapsulation layer; and
a touch sensor electrode on the second insulating layer.

6. The display device of claim 5, wherein the first reflection pattern includes a same material as the touch sensor electrode.

7. The display device of claim 5 or 6, wherein
the first color pattern is on the second insulating layer, and
the first insulating layer is on the touch sensor electrode.

8. The display device of any one of claims 5 to 7, further comprising a light blocking layer overlapping the touch sensor electrode in the thickness direction of the substrate, the light blocking layer on the first insulating layer;
optionally wherein a thickness of the first color pattern is greater than a thickness of the light blocking layer.

9. The display device of claim 8, wherein the light blocking layer comprises:
a first sub-light blocking layer extending from the first color filter;
a second sub-light blocking layer extending from the second color filter; and
a third sub-light blocking layer extending from the third color filter,
wherein the first sub-light blocking layer, the second sub-light blocking layer, and the third sub-light blocking layer overlap each other in the thickness direction of the substrate;
optionally wherein the third sub-light blocking layer is at least partially in a hole penetrating the first insulating layer such that the third sub-light blocking layer contacts the touch sensor electrode;
optionally wherein the third sub-light blocking layer comprises a same material as the first color pattern.

10. The display device of any one of claims 1 to 9, wherein the light of the first wavelength band is light of a red wavelength band, the light of the second wavelength band is light of a green wavelength band, and the light of the third wavelength band is light of a blue wavelength band.

11. The display device of any one of claims 1 to 10, further comprising:
a second reflection pattern on the encapsulation layer, the second reflection pattern overlapping the second light emitting unit in the thickness direction of the substrate, wherein the first insulating layer includes a second hole penetrating the first insulating layer and exposing the second reflection pattern; and
a second color pattern at least partially in the second hole and on the second reflection pattern exposed by the second hole;
optionally wherein the third color filter, the first color pattern, and the second color pattern comprise a same material.

12. The display device of claim 11, further comprising:
a third reflection pattern on the encapsulation layer and overlapping the third light emitting unit in the thickness direction of the substrate, wherein the first insulating layer includes a third hole penetrating the first insulating layer and exposing the third reflection pattern; and
a third color pattern at least partially in the third hole.

13. The display device of claim 6 or any claim when dependent on claim 6, wherein
the touch sensor electrode comprises a touch driving electrode and a touch sensing electrode, and
the display device further comprises a touch driver electrically connected to the touch driving electrode and the touch sensing electrode, wherein the touch driver is configured to detect an amount of change in capacitance formed between the touch driving electrode and the touch sensing electrode.

14. The display device of claim 11, wherein
the first color pattern comprises a (1-1)-th color pattern and a (1-2)-th color pattern, the (1-1)-th color pattern is in the first hole, the (1-2)-th color pattern is on the (1-1)-th color pattern, the (1-1)-th color pattern is configured to selectively transmit any one of the light of the second wavelength band or the light of the third wavelength band, and the (1-2)-th color pattern is configured to selectively transmit another one of the light of the second wavelength band or the light of the third wavelength band, and
the second color pattern comprises a (2-1)-th color pattern and a (2-2)-th color pattern, the (2-1)-th color pattern is in the second hole, the (2-2)-th color pattern is on the (2-1)-th color pattern, the (2-1)-th color pattern is configured to selectively transmit any one of the light of the first wavelength band or the light of the third wavelength band, and the (2-2)-th color pattern is configured to selectively transmit another one of the light of the first wavelength band or the light of the third wavelength band;
optionally further comprising:
a third reflection pattern on the encapsulation layer and overlapping the third light emitting unit in the thickness direction of the substrate, wherein the first insulating layer includes a third hole penetrating the first insulating layer and exposing the third reflection pattern;
a (3-1)-th color pattern in the third hole; and
a (3-2)-th color pattern on the (3-1)-th color pattern,
wherein the (3-1)-th color pattern is configured to selectively transmit any one of the light of the first wavelength band or the light of the second wavelength band, and the (3-2)-th color pattern is configured to selectively transmit another one of the light of the first wavelength band or the light of the second wavelength band.

15. An electronic device, comprising:
a display module configured to display an image; and
a processor configured to transmit an image data signal to the display module,
wherein the display module comprises the display device according to any one of claims 1 to 14.
